(19) **Europäisches Patentamt / European Patent Office / Office européen des brevets**

(11) **EP 4 564 340 A1**

(12) **EUROPEAN PATENT APPLICATION**
published in accordance with Art. 153(4) EPC

(43) Date of publication:
04.06.2025  Bulletin 2025/23

(21) Application number: 22969467.4

(22) Date of filing: 26.12.2022

(51) International Patent Classification (IPC):
*G09G 3/32* (2016.01)

(52) Cooperative Patent Classification (CPC):
**H10K 59/131; G09G 3/32; G09G 3/3233;
G09G 3/3266;** G09G 2300/0426; G09G 2300/0452;
G09G 2300/0819; G09G 2300/0842;
G09G 2300/0861; G09G 2310/08;
G09G 2320/0233; G09G 2320/0247; G09G 2330/02

(86) International application number:
**PCT/CN2022/141896**

(87) International publication number:
**WO 2024/138310 (04.07.2024 Gazette 2024/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Boe Technology Group Co., Ltd.**
  **Beijing 100015 (CN)**
• **Chengdu BOE Optoelectronics Technology Co.,
  Ltd.**
  **Chengdu, Sichuan 611731 (CN)**

(72) Inventors:
• **ZHANG, Tiaomei**
  **Beijing 100176 (CN)**
• **YU, Ziyang**
  **Beijing 100176 (CN)**
• **XIAO, Yunsheng**
  **Beijing 100176 (CN)**
• **JIANG, Zhiliang**
  **Beijing 100176 (CN)**
• **HU, Ming**
  **Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **PIXEL CIRCUIT AND DRIVING METHOD THEREFOR, AND DISPLAY PANEL AND DISPLAY APPARATUS**

(57)   A pixel circuit and a driving method therefor, and a display panel and a display apparatus, which relate to the technical field of display. The pixel circuit comprises: a driving transistor, a data writing module, a compensation adjustment module and a first reset module, wherein a gate electrode, first electrode and second electrode of the driving transistor are respectively connected to a first node, a second node and a third node; the data writing module is connected to a first scanning control signal end, a data signal end and the second node; the compensation adjustment module is connected to a second scanning control signal end, the first node and the third node; and the first reset module is connected to a first reset control signal end, the first node and a first initialization signal end. A first node and a second node can be fully reset by means of a first reset module, thereby ameliorating a screen-switching flicker phenomenon of a display panel at different refresh frequencies; and by means of prolonging the effective enabling time of a second scanning control signal, a data signal is fully written into the first node, and an effective charging time is prolonged.

EP 4 564 340 A1

Con 1    Con 2

N2

Reset
module

Data writing
module 11 ........ Da

N1

T3

Scan1

10

Compensation
adjustment
module 12

Reset
module

N3

Scan2

Con 1    Con 2

First reset
module 131 ——Vinit1

Re1

FIG. 4

## Description

Technical field

The present disclosure relates to the technical field of display, and particularly to a pixel circuit, a driving method thereof, a display panel, and a display apparatus.

Background

In recent years, with the rapid development of the display industry, the rigid LCD screen cannot meet people's pursuit of life gradually. Therefore, OLED display, which is famous for its flexibility, came into being. Of course, consumers' pursuit of display quality has never changed. The existing design uses some common control signal lines to save space, which makes the charging time under high frequency insufficient. How to effectively extend the charging time is the hot spot of the current phase of research; secondly, before the light-emitting, the potential of each node in the light-emitting pathway is different, which will also lead to the difference of display brightness of pixels with the same color, so how to effectively solve the difference of brightness display is also is the current phase of the study of the hot topic.

Summary

The purpose of the present disclosure is to provide a pixel circuit, a driving method thereof, a display panel and a display apparatus, which are used for improving the phenomenon that a display device is prone to splash when displaying.

In order to achieve the above purpose, the present disclosure provides the following technical solutions.

In one aspect, some embodiments of the present disclosure provide a pixel circuit. A pixel circuit, comprising: a drive transistor having a gate, a first electrode and a second electrode connected with a first node, a second node and a third node, respectively, the drive transistor is configured to provide a drive signal to a light-emitting device; a data writing module connected with a first scan control signal terminal, a data signal terminal and the second node, wherein the data writing module is configured to write a data signal provided by the data signal terminal to the second node under the control of a first scan control signal provided by the first scan control signal terminal; a compensation adjustment module connected with a second scan control signal terminal, the first node, and the third node, the compensation adjustment module is configured to control the conduction or disconnection between the first node and the third node under the control of a second scan control signal provided by the second scan control signal terminal; a first reset module connected with a first reset control signal terminal, the first node and a first initialization signal terminal; in one refresh frame period, when the compensation adjustment module is turned off, the first reset module is configured to write a first initialization signal provided by the first initialization signal terminal into the first node under the control of a first reset control signal; when the compensation adjustment module is turned on, the first reset module is configured to write the first initialization signal provided by the first initialization signal terminal into the first node and the third node under the control of the first reset control signal.

**In** some embodiments, in one refresh frame period, the time for which the second scan control signal controls the compensation adjustment module to be turned on is greater than or equal to four times the time for which the first scan control signal controls the data writing module to be turned on.

In some embodiments, in one refresh frame period, after the data writing module is turned off under the control of the first scan control signal, the compensation adjustment module continues to be turned on under the control of the second scan control signal, the time for which the second scan control signal controls the compensation adjustment module to continue to be turned on is greater than or equal to three times the time for which the first scan control signal controls the data writing module to be turned on.

In some embodiments, the first reset control signal terminal and the second scan control signal terminal are controlled in response to a same cascaded gate signal, and the cascaded gate signal is the second scan control signal.

In some embodiments, the first reset module comprises a first transistor, a gate of the first transistor is connected with the first reset control signal terminal, a first electrode of the first transistor is connected with the first initialization signal terminal, and a second electrode of the first transistor is connected with the gate of the drive transistor; the compensation adjustment module comprises a second transistor, a gate of the second transistor is connected with the second scan control signal terminal, a first electrode of the second transistor is connected with the gate of the drive transistor, and a second electrode of the second transistor is connected with the second electrode of the drive transistor; the data writing module comprises a fourth transistor, a gate of the fourth transistor is connected with the first scan control signal terminal, a first electrode of the fourth transistor is connected with the data signal terminal, and a second electrode of the fourth transistor is connected with the first electrode of the drive transistor.

In some embodiments, the pixel circuit further comprises a second reset module connected with a second reset control signal terminal, a second initialization signal terminal and the second node and/or the third node; the second reset module is configured to write a second initialization signal provided by the second initialization signal terminal to at least one of the second node and the third node under the control of the second reset control signal.

In some embodiments, the pixel circuit further comprises a light-emitting control module, the light-emitting control module comprises a fifth transistor and a sixth transistor; a gate of the fifth transistor is connected with a light-emitting control signal terminal, a first electrode of the fifth transistor is connected with a first power supply voltage terminal, and a second electrode of the fifth transistor is connected with the first electrode of the drive transistor; a gate of the sixth transistor is connected with the light-emitting control signal terminal, a first electrode of the sixth transistor is connected with the second electrode of the drive transistor, a second electrode of the sixth transistor is connected with a first electrode of the light-emitting device, and the connecting node is a fourth node; the light-emitting control module is configured to control the conduction or disconnection between the first power supply voltage terminal and the second node, and to control the conduction or disconnection between the third node and the fourth node under a light-emitting control signal provided by the light-emitting control signal terminal, and to provide a drive signal generated by the drive module to the light-emitting device.

In some embodiments, the pixel circuit further comprises a third reset module connected with a third reset control signal terminal, the fourth node and a third initialization signal terminal; the third reset module is configured to write a third initialization signal into the fourth node under the control of the third reset control signal.

In some embodiments, the second reset control signal terminal and the third reset control signal terminal are controlled in response to a same gate signal, and the gate signal is the third reset control signal.

In some embodiments, in a first display mode, the quantity of times the third reset control signal controls the second reset module to be turned on greater than the quantity of times the second scan control signal controls the compensation adjustment module to be turned on.

In some embodiments, the third reset control signal terminal and the first scan control signal terminal are controlled in response to a same cascaded gate signal, and the gate signal is the third reset control signal.

In some embodiments, the second reset module comprises an eighth transistor, a gate of the eighth transistor is connected with the second reset control signal terminal, a first electrode of the eighth transistor is connected with the second initialization signal terminal, and a second electrode of the eighth transistor is connected with the first electrode of the drive transistor; the third reset module comprises a seventh transistor, a gate of the seventh transistor is connected with the third reset control signal terminal, a first electrode of the seventh transistor is connected with the third initialization signal terminal, and a second electrode of the seventh transistor is connected with the second electrode of the sixth transistor. The pixel circuit further comprises a storage module, wherein the storage module comprises a first plate and a second plate, wherein the first plate is connected with the first power supply voltage terminal, and the second plate is connected with the gate of the drive transistor; the storage module is configured to store a potential of the first node.

In another aspect, an embodiment of the present disclosure provides a driving method applied to the pixel circuit aforementioned. The pixel circuit comprises: a drive transistor having a gate, a first electrode and a second electrode connected with a first node, a second node and a third node, respectively; a data writing module connected with a first scan control signal terminal, a data signal terminal and the second node; a compensation adjustment module connected with a second scan control signal terminal, the first node, and the third node; the pixel circuit operates in a plurality of display modes, wherein in a first display mode, the first display mode comprises one refresh frame period and at least one hold frame period, a refresh frame comprises a data writing and holding phase and a light-emitting phase; the data writing and holding phase comprises a data writing phase and a data holding phase, during the data writing phase, the data writing module is turned on under the control of the first scan control signal to transmit a data signal received at the data signal terminal to the first node, the drive transistor transmits the data signal from the second node to the third node, and the compensation adjustment module transmits a data signal of the third node to the first node under the control of the second scan control signal; during the data holding phase, the data writing module is turned off under the control of the first scan control signal, and the compensation adjustment module continues to be turned on to fully write the data signal in the circuit into the first node; during the light-emitting phase, the light-emitting control module transmits a voltage signal provided by a first power supply voltage terminal to the second node under the control of a light-emitting control signal, and the drive transistor turns on the second node and the third node according to voltages of the first node and the second node, and transmits the voltage signal to a light-emitting device to drive the light-emitting device to emit light.

In some embodiments, the pixel circuit further comprises a first reset module, a second reset module, and a third reset module; the first reset module is connected with a first reset control signal terminal, the first node and a first initialization signal terminal; the second reset module is connected with a second reset control signal terminal, a second initialization signal terminal and the second node; the third reset module is connected with a third reset control signal terminal, a fourth node and a third initialization signal terminal; the refresh frame further comprises a first reset phase, a second reset phase and a third reset phase, during the first reset phase, the first reset module is turned on under the control of a first reset control signal and transmits a first initialization signal to the first node; during the second reset phase, the first reset module continues to be turned on, the compensation adjustment module is turned on under the control of the second scan control signal, and transmits the first initialization signal to the first node, the second node and the third node; during the third reset phase, the second reset module and the third reset module are respectively turned on under the control of a second reset control signal and a third reset control signal, and the second reset module transmits a second initialization signal received at the second initialization signal terminal to the second node and the third node; the third reset module transmits a third initialization signal received at the third initialization signal terminal to the fourth node.

In some embodiments, a hold frame comprises an adjustment phase in which the light-emitting device continues to emit light, only the second reset module and the third reset module in the pixel circuit are turned on, the second reset module transmits the second initialization signal received at the second initialization signal terminal to the second node, and the third reset module transmits the third initialization signal received at the third initialization signal terminal to the fourth node.

In another aspect, embodiments of the present disclosure provide a display panel, comprising:
a base substrate and a plurality of sub-pixels located on the base substrate, the sub-pixels are arranged in an array along a first direction and a second direction, at least one sub-pixel comprises a circuit unit and a light-emitting device, the circuit unit comprises a plurality of control signal lines and the pixel circuit aforementioned, the pixel circuit is configured to output a corresponding driving current to the light-emitting device under the control of the control signal lines; the pixel circuit comprises a plurality of transistors, each of which comprises a gate, a first electrode and a second electrode; a circuit layer arranged on the base substrate, wherein a plurality of control signal lines extending in the first direction and alternately arranged in the second direction are included in the circuit layer, wherein the first direction and the second direction intersect each other; the control signal line is connected with a gate of the transistor for providing a gate control signal; a gate of at least one transistor and the control signal line are located in different film layers.

In some embodiments, the plurality of transistors comprises a drive transistor, a second transistor and a fourth transistor, a first electrode of the second transistor is connected with a second electrode of the drive transistor, a second electrode of the second transistor is connected with a gate of the drive transistor, a second electrode of the fourth transistor is connected with the first electrode of the drive transistor, the first electrode of the fourth transistor is connected with a data signal line; the control signal line comprises a first scan control signal line and a second scan control signal line, wherein the first scan control signal line is connected with a gate of the fourth transistor for providing a first scan control signal; the second scan control signal line is connected with a gate of the second transistor for providing a second scan control signal; the first scan control signal line and the gate of the fourth transistor are located in different film layers.

In some embodiments, the second scan control signal line and the gate of the second transistor are located in different film layers.

In some embodiments, the pixel circuit further comprises a first transistor, a second electrode of the first transistor is connected to the gate of the drive transistor, and a plurality of first reset control signal lines extending in the first direction and alternately arranged in the second direction are also included in the circuit layer; the first reset control signal line is connected with a gate of the first transistor for providing a first reset control signal; the first reset control signal line and the gate of the first transistor are located in different film layers.

In some embodiments, the conductivity of the control signal line is greater than the conductivity of the gate of the transistor when the control signal line and the gate of the transistor are located in different film layers.

In some embodiments, the pixel circuit further comprises a first transistor with a second electrode connected with a gate of the drive transistor and an eighth transistor with a second electrode connected with a first electrode of the drive transistor; the circuit layer also comprises a plurality of first reset control signal lines and a plurality of third reset control signal lines extending along the first direction and alternately arranged in the second direction, wherein the first reset control signal line and the gate of the first transistor are of an integral structure for providing a first reset control signal, and the third reset control signal line and a gate of the eighth transistor are of an integral structure for providing a third reset control signal; the pixel circuit further comprises a fifth transistor, a sixth transistor and a seventh transistor, a second electrode of the fifth transistor is connected to a first electrode of the drive transistor, a first electrode of the sixth transistor is connected to a second electrode of the drive transistor, a second electrode of the seventh transistor is connected to a second electrode of the sixth transistor; the third reset control signal line and a gate of the seventh transistor are of an integral structure; the circuit layer also comprises a plurality of light-emitting control signal lines extending along the first direction, wherein the light-emitting control signal lines and gates of the fifth transistor and the sixth transistor are of an integral structure; the second scan control signal line and the gate of the second transistor are of an integral structure providing a second scan control signal; the pixel circuit also comprises a capacitor, the capacitor comprises a first plate and a second plate, the first plate and the gate of the drive transistor are of an integral structure, an orthographic projections of the second plate and the first plate on the base substrate are at least partially overlapped; adjacent second plates in a sub-pixel row arranged in the first direction are connected with each other.

In some embodiments, the circuit layer comprises a first semiconductor layer disposed away from the base substrate, the first semiconductor layer comprises active layers of a plurality of transistors, the active layer comprises a first electrode, a second electrode, and a channel region connecting the first electrode and the second electrode of the transistor; active layers of the first transistor, the second transistor, the drive transistor, the fifth transistor, the sixth transistor and the seventh transistor are of an integral structure, and an orthographic projection of the active layers of the fourth transistor and the eighth transistor on the base substrate does not overlap an orthographic projection of the active layer of the integral structure on the base substrate.

In some embodiments, the circuit layer further comprises a first conductive layer disposed on a side of the first semiconductor layer away from the base substrate; the first conductive layer comprises the second scan control signal line, the first reset control signal line, the third reset control signal line, the light-emitting control signal line and the first plate; the first conductive layer also comprises a fourth gate block, the fourth gate block and a gate of the fourth transistor are of an integral structure, and the fourth gate block is located between the first reset control signal line and the second scan control signal line in the second direction.

In some embodiments, the circuit layer further comprises a plurality of first initialization signal lines, a plurality of third initialization signal lines, a plurality of data signal lines and a plurality of first power supply voltage lines extending in the second direction, the first initialization signal line is connected with a first electrode of the first transistor, the third initialization signal line is connected with a first electrode of the eighth transistor, the first power supply voltage line is connected with a second plate of the capacitor and a first electrode of the fifth transistor, and the data signal line is connected with a first electrode of the fourth transistor, the first initialization signal line connected with a same column of pixel circuits is located between the first power supply voltage line and the data signal line, and the third initialization signal line is located on a side of the data signal line away from the first initialization signal line; the circuit layer further comprises a plurality of the second initialization signal lines extending along the first direction, the second initialization signal line is connected with a first electrode of the seventh transistor; the second initialization signal line is located on a side of the first reset control signal line away from the second scan control signal line.

In some embodiments, the circuit layer further comprises a second conductive layer, a third conductive layer, and a fourth conductive layer sequentially disposed on a side of the first conductive layer away from the first semiconductor layer; the second conductive layer comprises a second plate of the capacitor and the second initialization signal line; the third conductive layer comprises the first scan control signal line, an orthographic projection of the first scan control signal line on the base substrate and an orthographic projection of the fourth gate block on the base substrate overlap at least partially, with the overlapping area accounting for more than 85% of the area of the fourth gate block; the fourth conductive layer comprises the data signal line, the first power supply voltage line, the first initialization signal line and the third initialization signal line.

In some embodiments, the third conductive layer further comprises a plurality of first adapters extending in the second direction, the first adapter comprises a first end, a third end and a second end between the first end and the third end, a second electrode of the fourth transistor is connected with the first end of the first adapter, a second electrode of the eighth transistor is connected with the third end of the first adapter, the second end of the first adapter is connected to a first electrode of the third transistor through a via; orthographic projections of the first adapter and the data signal line on the base substrate overlap at least partially, with the overlapping area accounting for more than 90% of the area of the first adapter.

In some embodiments, an active layer of the first transistor comprises a channel connection region, and an orthographic projection of the first power supply voltage line on the base substrate overlaps at least partially an orthographic projection of the channel connection region of the first transistor on the base substrate; the second conductive layer further comprises a shield, an active layer of the second transistor comprises a channel connection region, an orthographic projection of the shield on the base substrate and an orthographic projection of the channel connection region of the second transistor on the base substrate at least partially overlap; and/or, an orthographic projection of the shield on the base substrate at least partially overlaps with an orthographic projection of a second electrode of the first transistor on the base substrate; the shield is connected with the third initialization signal line or the first power supply voltage line.

In some embodiments, the first initialization signal line is connected with a first connection electrode line extending in the first direction through a via to form a grid-like structure; and/or, the second initialization signal line is connected with a second sub-initialization signal line extending in the second direction through a via to form a grid-like structure.

In another aspect, embodiments of the present disclosure also provide a display apparatus comprising a display region and at least one peripheral region adjacent to the display region, wherein a plurality of pixel circuits aforementioned are provided in the display region, and a gate drive circuit is provided in the peripheral region, the gate drive circuit is used for providing corresponding gate signals to a reset control signal terminal, a first scan control signal terminal and a second scan control signal terminal of the pixel circuit. The gate drive circuit comprises a first gate drive unit and a second gate drive unit, wherein the first gate drive unit is connected with the first scan control signal terminal of each of the pixel circuits, and the second gate drive unit is connected with the second scan control signal terminal of each of the pixel circuits; the first gate drive unit is configured to provide a first scan control signal of a first frequency to the first scan control signal terminal; the second gate drive unit is configured to provide a second scan control signal of a second frequency to the second scan control signal terminal; in one refresh frame period, the second frequency is equal to the first frequency, and the effective duration of the second scan control signal is greater than the effective duration of the first scan control signal.

In some embodiments, the second gate drive unit is further connected with the first reset control signal terminal of various pixel circuits, the first reset control signal terminal and the second scan control signal terminal of a same pixel circuit are respectively connected with output terminals of different stages of the second gate drive unit, and in one refresh frame period, the time when the first reset control signal terminal receives the effective level of the second scan control signal is earlier than the time when the second scan control signal terminal receives the effective level of the second scan control signal .

In some embodiments, the gate drive circuit further comprises a first reset drive unit connected with a second reset control signal terminal and a third reset control signal terminal of various pixel circuits, the second reset control signal terminal and the third reset control signal terminal of a same pixel circuit are connected with output terminals of a same stage of the first reset drive unit, the first reset drive unit is configured to provide a third reset control signal of a third frequency to the output terminals of the same stage; wherein in a first display mode, the third frequency is greater than the first frequency, and the effective duration of the third reset control signal is equal to the effective duration of the first scan control signal.

Brief Description of Drawings

In order to more clearly illustrate the technical aspects of the present disclosure, a brief description will be given below of the drawings required for use in some embodiments of the present disclosure. It will be apparent that the drawings described below are only drawings of some embodiments of the present disclosure, and other drawings may be obtained from these drawings to those of ordinary skill in the art. In addition, the drawings in the following description may be regarded as schematic diagrams and are not a limitation on the actual dimensions of the product, the actual flow of the method, the actual timing of the signals and the like involved in the embodiments of the present disclosure.

FIG. 1 is a schematic diagram of distribution of a display panel;
FIGS. 2a and 2b are schematic diagrams of a planar structure of a display panel;
FIG. 3 is a schematic diagram of a cross-sectional structure of a display panel;

FIG. 4 is a schematic diagram of a structure of a pixel drive circuit in accordance with an embodiment of the present disclosure;
FIG. 5 is a schematic diagram of a structure of another pixel drive circuit according to an embodiment of the present disclosure;
FIG. 6 is a schematic diagram of a structure of yet another pixel drive circuit in accordance with an embodiment of the present disclosure;
FIG. 7 is a timing diagram of a pixel circuit according to an embodiment of the present disclosure;
FIG. 8 is a timing diagram of another pixel circuit according to an embodiment of the present disclosure;
FIG. 9 is a schematic diagram of a structure of a display panel according to an embodiment of the present disclosure;
FIG. 9a is a schematic diagram of a structure of the display panel in FIG. 9 after a pattern of a first semiconductor layer is formed;
FIG. 9b and FIG. 9c are schematic diagrams of a structure of the display panel in FIG. 9 after a pattern of a first conductive layer is formed;
FIG. 9d and FIG. 9e are schematic diagrams of a structure of the display panel in FIG. 9 after a pattern of a second conductive layer is formed;
FIG. 9f is a schematic diagram of a structure of the display panel in FIG. 9 after a fourth insulating layer is formed;
FIG. 9g is a plan schematic diagram of a plurality of vias in FIG. 9f;
FIGS. 9h and 9i are schematic diagrams of a structure of the display panel in FIG. 9 after a pattern of a third conductive layer is formed;
FIG. 9j is a schematic diagram of another structure of the display panel in FIG. 9 after a pattern of a third conductive layer is formed;
FIG. 9k is a schematic diagram of a structure of the display panel in FIG. 9 after a fifth insulating layer is formed;
FIG. 9l is a plan schematic diagram of a plurality of vias in FIG. 9k;
FIG. 9m is a schematic diagram of a structure of the display panel in FIG. 9 after a pattern of a fourth conductive layer is formed;
FIG. 10 is a schematic diagram of a structure of another display panel according to an embodiment of the present disclosure;
FIG. 10a is a schematic diagram of a structure of the display panel in FIG. 10 after a pattern of a second conductive layer is formed;
FIG. 10b is a plan schematic diagram of the display panel in FIG. 10 forming a plurality of vias in the fourth insulating layer;
FIG. 10c is a schematic diagram of a structure of the display panel in FIG. 10 after a pattern of a third conductive layer is formed;
FIG. 11 is a schematic diagram of a structure of another display panel according to an embodiment of the present disclosure;

FIG. 11a is a schematic diagram of a structure of the display panel in FIG. 11 after a pattern of a second conductive layer is formed;

FIG. 11b is a plan schematic diagram of the display panel in FIG. 11 forming a plurality of vias in the fourth insulating layer;

FIG. 11c is a schematic diagram of a structure of the display panel in FIG. 11 after a pattern of a third conductive layer is formed;

FIG. 11d is a plan schematic diagram the display panel in FIG. 11 forming a plurality of vias in the fifth insulating layer;

FIG. 11e is a schematic diagram of a structure of the display panel in FIG. 11 after a pattern of a fourth conductive layer is formed;

FIG. 12 is a schematic diagram of another structure of the display panel in FIGS. 10 and 11 after a pattern of a first semiconductor layer is formed;

FIG. 13 is a schematic diagram of a structure of another display panel according to an embodiment of the present disclosure;

FIG. 14 is a schematic diagram of a structure of a display apparatus according to an embodiment of the present disclosure;

FIG. 15 is a schematic diagram of a structure of another display apparatus according to an embodiment of the present disclosure;

FIG. 16 is a schematic diagram of a structure of a display apparatus according to an embodiment of the present disclosure;

FIG. 17 is a schematic diagram of a structure of still further display apparatus according to an embodiment of the present disclosure.

Detailed Description

The technical schemes in the embodiments of present disclosure will be described clearly and completely with reference to the drawings. The described embodiments are apparently only part of the embodiments of the present disclosure, rather than all of the embodiments. All other embodiments obtained by those of ordinary skill in the art based on the embodiments provided by the present disclosure fall within the scope of protection of the present disclosure.

Unless otherwise defined, technical terms or scientific terms used in the present disclosure should have the meanings as commonly understood by those of ordinary skill in the art that the present disclosure belongs to. The "first", "second" and similar terms used in the present disclosure do not indicate any order, quantity, or importance, but are used only for distinguishing different components. Similarly, similar words such as "a", "an" or "the" do not denote a limitation on quantity, but rather denote the presence of at least one. "Include", "contain", or similar words mean that elements or objects appearing before the words cover elements or objects listed after the words and their equivalents, but do not exclude other elements or objects. Terms such as "connection" or "link" are not limited to a physical or mechanical connection, but may include an electrical connection, whether direct or indirect. "Upper", "lower", "left", "right", etc., are used to represent relative position relations, and when an absolute position of a described object is changed, the relative position relation may also be correspondingly changed. "Continuously extended", "integral structure", "monolithic structure" or similar expressions denote that multiple elements, components, structures and/or portions are located on the same layer and are usually formed by a same patterning process during the manufacturing process, and that there are no gaps or discontinuities between these elements, components, structures and/or portions, but rather a structure that extends continuously.

"At least one of A, B and C" has the same meaning as "at least one of A, B or C" and includes the following combinations of A, B and C: A only, B only, C only, a combination of A and B, a combination of A and C, a combination of B and C, and a combination of A, B and C. "A and/or B" includes the following three combinations: A only, B only, and a combination of A and B.

In a circuit structure (for example, a pixel circuit) provided by an embodiment of the present disclosure, the transistor used in the circuit structure may be a Thin Film Transistor (TFT), a field effect transistor (Metal Oxide Semiconductor, or MOS) or other switching devices with the same characteristics, and all embodiments of the present disclosure are illustrated using thin film transistors as examples.

In the circuit structure provided by an embodiment of the present disclosure, a first electrode of each transistor employed is one of a source and a drain, and a second electrode of each transistor is the other of a source and a drain. Since the source and drain of the transistor may be structurally symmetrical, the source and drain of the transistor may be structurally indistinguishable, that is, the first electrode and the second electrode of the transistor in the embodiment of the present disclosure may be structurally indistinguishable. Exemplarily, in the case where the transistor is a P-type transistor, the first electrode of the transistor is a source and the second electrode is a drain; exemplarily, in the case where the transistor is an N-type transistor, the first electrode of the transistor is a drain and the second electrode is a source.

In the circuit structure provided by an embodiment of the present disclosure, nodes such as the first node, the second node and the like do not represent actually existing components, but rather represent confluence points of related connections in the circuit diagram, that is, these nodes are nodes that are equivalently formed from the confluence points of related connections in the circuit diagram.

The transistors included in the circuit structure provided in the embodiment of the present disclosure may all be N-type transistors, or may all be P-type transistors, or a portion can be N-type transistors while another portion can be P-type transistors. In the present disclosure, "effective level" refers to a level at which a transistor can be turned on. Herein, the P-type transistor can be turned on under the control of a low-level signal, and the N-type transistor can be turned on under the control of a high-level signal.

Hereinafter a schematic description will be given by taking a case in which the transistors included in the circuit structure provided in the embodiment of the present disclosure are all P-type transistors as an example.

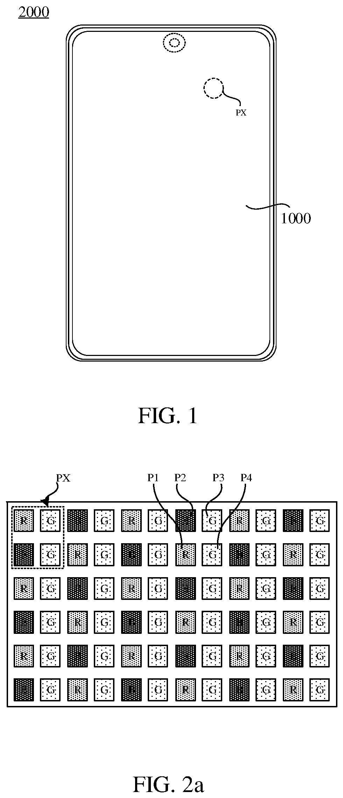

As shown in FIG. 1, some embodiments of the present disclosure provide a display apparatus 2000 including a display panel 1000.

In some embodiments, the above-described display apparatus 2000 may for example be an OLED (Organic Light-emitting Diode) display apparatus.

Exemplarily, the display apparatus 2000 also includes a frame, a display driver IC (Integrated Circuit) and other electronic accessories, etc.

Exemplarily, the above-described display apparatus 2000 may be in any display apparatus that displays contents, whether they are moving (for example, videos) or fixed (for example, still images) and whether they are texts or images. More specifically, it is contemplated that the display apparatuses of the described embodiments may be implemented in or associated with a variety of electronic devices such as (but not limited to) a mobile phone, a wireless device, a personal digital assistant (PDA), a handheld or portable computer, a GPS receiver/navigator, a camera, an MP4 video player, a video camera, a game console, a watch, a clock, a calculator, a TV monitor, a tablet display, a computer monitor, a car display (e.g., an odometer display), an avigraph, a cockpit controller and/or display, a display for camera view (e.g., a display of a rearview camera in a car), an electronic photo, an electronic billboard or sign, a projector, a building structure, a package structure, and an aesthetic structure (e.g., a display for an image of a piece of jewelry).

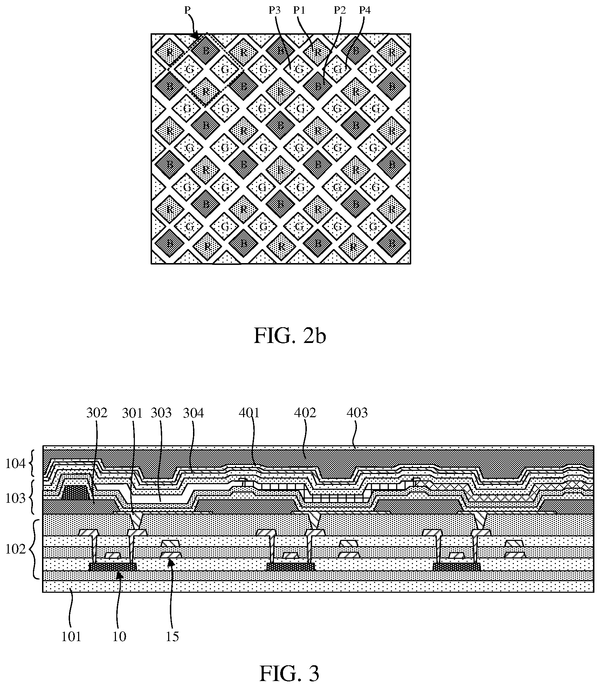

FIGS. 2a and 2b are schematic diagrams of a planar structure of a display panel 1000 in FIG. 1. In an exemplary implementation mode, the display panel may include a plurality of pixel units P arranged in a matrix manner, and at least one pixel unit P may include a first sub-pixel P1 emitting a first color light, a second sub-pixel P2 emitting a second color light, and a third sub-pixel P3 emitting a third color light and a fourth sub-pixel P4 emitting a third color light. Each of the four sub-pixels may include a circuit unit and a light-emitting device, the circuit unit may include a scan control signal line, a data signal line and a light-emitting signal line and a pixel circuit, and the drive circuit is respectively connected with the scan control signal line, the data signal line, and the light-emitting signal line. The pixel circuit is configured to receive the data voltage transmitted by the data signal line and output a corresponding current to the light-emitting device under the control of the scan control signal line and the light-emitting signal line. The light-emitting device in each sub-pixel is connected with a pixel circuit of the sub-pixel where the light-emitting device is located, and the light-emitting device is configured to emit light with a corresponding brightness in response to a current output by the pixel circuit of the sub-pixel where the light-emitting device is located.

In an exemplary implementation mode, the first sub-pixel P1 may be a red sub-pixel (R) emitting red light, the second sub-pixel P2 may be a blue sub-pixel (B) emitting blue light, and the third sub-pixel P3 and the fourth sub-pixel P4 may be green sub-pixels (G) emitting green light. In exemplary embodiments, the sub-pixel may have a shape of a rectangle, a rhombus, a pentagon, or a hexagon. In an exemplary implementation, four sub-pixels may be arranged in a manner of square to form a GGRB pixel arrangement, as shown in FIG. 2a. In another exemplary implementation, the four sub-pixels may be arranged in a manner of diamond to form an RGBG pixel arrangement, as shown in FIG. 2b. In other exemplary implementations, the four sub-pixels may be arranged in a manner of horizontal juxtaposition or vertical juxtaposition or the like. In an exemplary implementation mode, a pixel unit may include three sub-pixels, and the three sub-pixels may be arranged side by side horizontally, side by side vertically, or in a manner like a Chinese character "品", which is not limited here in the present disclosure.

In an exemplary embodiment, multiple sub-pixels sequentially arranged in the horizontal direction are referred to as a pixel row, and multiple sub-pixels sequentially arranged in the vertical direction are referred to as a pixel column; the multiple pixel rows and the multiple pixel columns together form a pixel array arranged in an array.

FIG. 3 is a schematic diagram of a cross-sectional structure of a display panel, illustrating the structure of three sub-pixels of the display panel. As shown in FIG. 3, on a plane perpendicular to the display panel, the display panel may include a circuit layer 102 disposed on the base substrate 101, a light-emitting structure layer 103 disposed on a side of the circuit layer 102 away from the base substrate, and an encapsulation layer 104 disposed on a side of the light-emitting structure layer 103 away from the base substrate. In some possible implementation modes, the display panel may include other film layers, such as a post spacer, which is not limited here in the present disclosure.

In an exemplary implementation mode, the base substrate 101 may be a flexible base substrate or a rigid base substrate. The circuit layer 102 of each sub-pixel may include a plurality of signal lines and a pixel circuit, the pixel circuit may include a plurality of transistors and a storage capacitor. In FIG. 3, only one drive transistor 10 and one storage capacitor 15 are taken as an example for illustration. The light-emitting structure layer 103 of each sub-pixel may include a plurality of film layers constituting a light-emitting device, and the plurality of film layers may include an anode 301, a pixel definition layer 302, an organic light-emitting layer 303 and cathode 304, the anode 301connected is with a drain electrode of the drive transistor 210 through a via, the organic light-emitting layer 303 is connected with the anode 301, the cathode 304 is connected with the organic light-emitting layer 303, and the organic light-emitting layer 303 emits light of corresponding color under drive of the anode 301 and the cathode 304. The encapsulation layer 104 may include a first encapsulation layer 401, a second encapsulation layer 402, and a third encapsulation layer 403 that are stacked. The first encapsulation layer 401 and the third encapsulation layer 403 may be made of an inorganic material, the second encapsulation layer 402 may be made of an organic material, and the second encapsulation layer 402 is disposed between the first encapsulation layer 401 and the third encapsulation layer 403 so as to prevent external water vapor from entering the light-emitting structure layer 103.

In an exemplary embodiment, the organic emitting layer 303 may include a Hole Injection Layer (HIL), a Hole Transport Layer (HTL), an Electron Block Layer (EBL), an Emitting Layer (EML), a Hole Block Layer (HBL), an Electron Transport Layer (ETL), and an Electron Injection Layer (EIL) which are stacked. In an exemplary implementation mode, hole injection layers and electron injection layers of all sub-pixels may be connected together as a common layer, hole transport layers and electron transport layers of all the sub-pixels may be connected together as a common layer, hole block layers of all the sub-pixels may be connected together as a common layer, and emitting layers and electron block layers of adjacent sub-pixels may be slightly overlapped with each other, or may be isolated from each other.

In exemplary embodiments, the pixel circuit may have a structure of 3T1C, 4T1C, 5T1C, 5T2C, 6T1C, 7T1C, or 8T1C, which is not specifically defined herein.

OLED pixels are driven to emit light by a current generated by a Driving Thin Film Transistor (DTFT) in a saturated state. However, the current manufacturing process of OLED panel is difficult to ensure the uniformity of the DTFT threshold voltage. Even if the data signal loaded into the drive circuit in each sub-pixel (embodied in gray scale) is the same, the driving current transmitted to the light-emitting elements in different sub-pixels will be inconsistent, which will lead to the problem of uneven brightness of each pixel in OLED light-emitting apparatus. In addition, the current reset circuit can only reset the gate of the DTFT and the anode of the light-emitting element, but cannot reset the first electrode and the second electrode of the DTFT. In this way, when switching at different frequencies, the variable refresh rate (VRR) is poor due to the difference in reset voltages of the first electrode and the second electrode of the DTFT in the refresh frame and the hold frame, resulting in a brightness difference, and a brightness flicker can be observed by the human eye. In addition, since the compensation transistor T2 and the data writing transistor T4 in the pixel circuit share a gate signal line, the charging time at high frequency is insufficient in the existing design. How to effectively extend the charging time is the hot spot of research at this phase. All these problems affect the display effect of the product.

In view of this, the embodiment of the present disclosure provides a pixel circuit, a driving method thereof, a display panel and a display apparatus, which are used for improving the flicker problems during screen switching, prolonging the effective charging time and the like while improving the display effect.

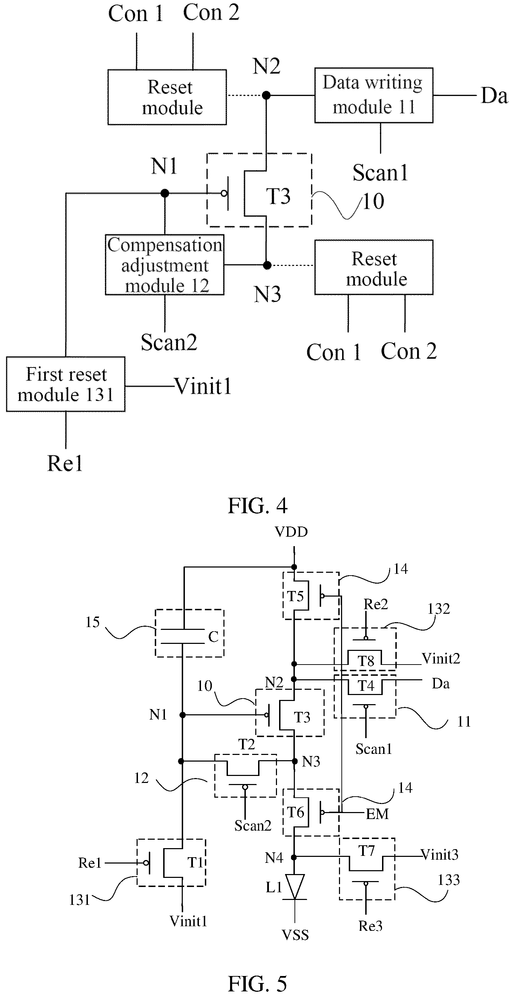

On this basis, some embodiments of the present disclosure provide a pixel circuit 100, as shown in FIG. 4, which includes a drive transistor 10, a data writing module 11, a compensation adjustment module 12, and at least one reset module.

A gate, a first electrode and a second electrode of the drive transistor 10 are connected with a first node N1, a second node N2 and a third node N3, respectively. The drive transistor is configured to generate a driving current for driving the light-emitting device.

The data writing module 11 is connected with a first scan control signal terminal Scan1, a data signal terminal Da, and a second node N2. The data writing module 11 is configured to write the data signal Da supplied from the data signal terminal to the second node N2 under the control of the first scan control signal terminal Scan1.

The compensation adjustment module 12 is connected with the second scan control signal terminal Scan2, the first node N1 and the third node N3. The compensation adjustment module turns on or off the first node N1 and the third node N3 under the control of the second scan control signal terminal Scan2.

At least one reset module 13 is connected with a reset control signal terminal Con1, a circuit node and an initialization signal terminal Con2. The reset module is configured to write an initialization signal provided by the initialization signal terminal into at least one circuit node under the control of the reset control signal provided by the reset control signal terminal.

In some embodiments, as shown in FIG. 4, the reset module may be connected to the first node N1, and the reset module writes the initialization signal provided by the initialization signal terminal to the first node N1 under the control of the reset control signal provided by the reset control signal terminal. In addition, the reset module can also be connected to the second and third nodes, with the connection shown using dashed lines. The circuit nodes are not limited to the first, second and third nodes. According to the actual needs of the circuit, the reset module can also be arranged at other circuit nodes for providing initialization signals.

In some embodiments, referring to FIGs. 4 and 5, the reset module connected to the first node N1 is a first reset module 131, which is connected with a first reset control signal terminal Re1, the first node N1 and a first initialization signal terminal Vinit1. In one refresh frame period, when the compensation adjustment module 12 is turned off, the first reset module 131 is configured to write the first initialization signal provided by the first initialization signal terminal into the first node N1 under the control of the first reset control signal to clear the residual voltage; when the compensation adjustment module 12 is turned on, the first reset module 131 is configured to write the first initialization signal provided by the first initialization signal terminal to the first node N1, the second node N2, and the third node N3 under the control of the first reset control signal.

It should be noted that the display panel in which the pixel circuit is located includes a plurality of display modes, such as a first display mode, a second display mode, etc., wherein the display mode includes at least one refresh frame period. During the refresh frame period, the pixel circuit normally refreshes and operates under the control of the gate control signal. The display mode may also include a hold frame in which the light-emitting element continuously emits light, but only some of the modules in the pixel circuit are continue to be refreshed under the control of the gate control signal.

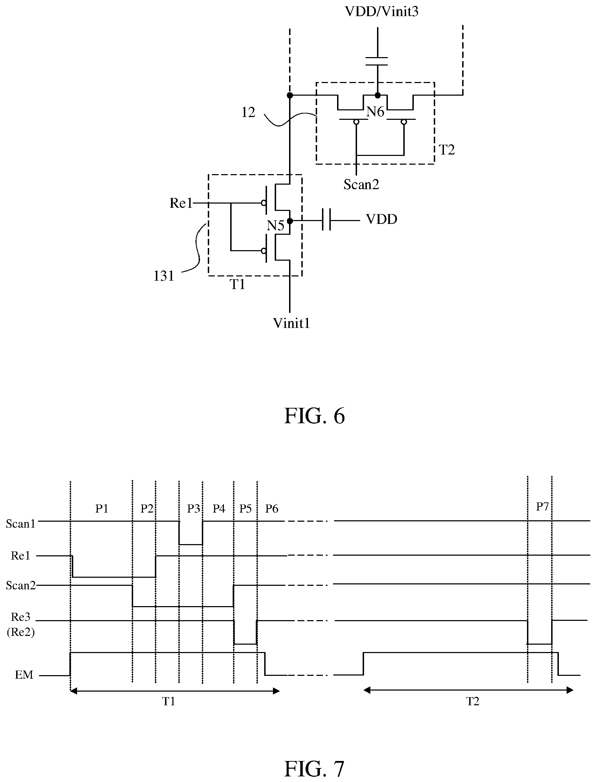

As shown in FIG. 7, T1 is a refresh frame period of the pixel circuit, T2 is a hold frame period of the pixel circuit, and the first display mode may include one refresh frame period and at least one display frame period.

a) It should be noted that the compensation adjustment module 12 turns off or turns on means that when the second scan control signal is an ineffective level signal, the compensation adjustment module 12 turns off the signal transmission channel between the node N1 and the node N3; when the second scan control signal is an effective level signal, the compensation adjustment module 12 turns on the signal transmission channel between the node N1 and the node N3.

In some embodiments, the first reset control signal terminal Re1 and the second scan control signal terminal Scan2 may receive the same gate signal, i.e., the first reset control signal terminal Re1 and the second scan control signal terminal Scan2 are controlled in response to the same gate signal, and the gate signal is the second scan control signal. This can reduce the quantity of GOAs, which is beneficial to narrow the bezel of the display panel.

In some embodiments, the second scan control signal controls the compensation adjustment module 12 to be turned on for a time greater than or equal to four times the time the first scan control signal controls the data writing module 11 to be turned on. Therefore, after the data writing module 11 writes the data signal provided by the data signal terminal Da to the second node N2, and the drive transistor 10 is turned on to transmit the data signal of the second node N2 to the first node N1 in response to the voltage of the N1 node, the data writing module 11 is turned off under the control of the first scan control signal, and the compensation adjustment module 12 can continue to be turned on for at least three lines under the control of the second scan control signal, that is, in one refresh frame period, the second scan control signal controls the compensation adjustment module 12 to continue to be turned on for a time greater than or equal to three times the first scan control signal controls the data writing module 11 to be turned on to fully write the data signal in the circuit into the first node N1, thus prolonging the effective charging time and fully writing the data signal into the first node N1, which is beneficial to high-frequency driving.

In some embodiments, with continued reference to FIG. 5, the first reset module 131 includes a first transistor. A gate of the first transistor is connected with the first reset control signal terminal Re1, a first electrode of the first transistor is connected with the first initialization signal terminal Vinit1, and a second electrode of the first transistor is connected with a gate of the drive transistor 10.

The compensation adjustment module 12 includes a second transistor, a gate of the second transistor is connected with the second scan control signal terminal Scan2, a first electrode of the second transistor is connected with the gate of the drive transistor, and a second electrode of the second transistor is connected with the second electrode of the drive transistor.

The data writing module 11 includes a fourth transistor, a gate of the fourth transistor is connected with the first scan control signal terminal Scan1, a first electrode of the fourth transistor is connected with the data signal terminal Da, and a second electrode of the fourth transistor is connected with the first electrode of the drive transistor.

Exemplarily, when the level of the second scan control signal received by the second scan control signal terminal Scan2 is an ineffective level, the second transistor is turned off under the control of the second scan control signal, and the first transistor writes the first initialization signal to the first node N1 under the control of the first reset control signal provided by the first reset control signal terminal Re1; when the level of the second scan control signal received by the second scan control signal terminal Scan2 is an effective level, the second transistor is turned on under the control of the second scan control signal and writes the first initialization signal to the first node, the second node and the third node N3. It is to be noted that the writing path of the above-described first initialization signal is as follows: the first initialization signal is sequentially written to the first node N1 through the first electrode and the second electrode of the first transistor, to the third node N3 through the first electrode and the second electrode of the second transistor, and finally to the third node N3 through the first electrode and the second electrode of the third transistor.

Exemplarily, when the level of the first scan control signal received by the first scan control signal terminal Scan1 is an effective level, the fourth transistor is turned on to write the data signal supplied by the data signal terminal Da to the second node N2, and the drive transistor is turned on to transmit the data signal of the second node N2 to the first node N1 in response to the voltage of the node N1.

In some embodiments, with continued reference to FIG. 5, the pixel circuit includes a second reset module 132 connected to the node N2 and connected with a second reset control signal terminal Re2, a second initialization signal terminal Vinit2, and the second node N2; the second reset module 132 is configured to write the second initialization signal provided by the second initialization signal terminal Vinit2 to at least one of the second node N2 and the third node N3 under the control of the second reset control signal.

Exemplarily, the pixel circuit may include two reset modules, a first reset module 131 connected to the first node N1 and a second reset module 132 connected to the second node N2. The second reset module 132 is connected with the second reset control signal terminal Re2, the second initialization signal terminal Vinit2 and the second node N2; the second reset module 132 is configured to write the second initialization signal provided by the second initialization signal terminal Vinit2 to at least one of the second node N2 and the third node N3 under the control of the second reset control signal. That is, when the drive transistor is turned off, the second reset module 132 writes the second initialization signal provided by the second initialization signal terminal into the second node N2; when the drive transistor is turned on, the second reset module 132 writes the second initialization signal provided by the second initialization signal terminal to the second node N2 and the third node N3 at the same time.

In some embodiments, with continued reference to FIG. 5, the pixel circuit also includes a light-emitting control module 14. The light-emitting control module 14 is connected with a first power supply voltage terminal VDD, a light-emitting control signal terminal EM, the second node N2, the third node N3 and a light-emitting device L1. The light-emitting control module 14 is configured to transmit a driving current signal to the light-emitting device L1 in cooperation with the drive transistor 10 under the control of a signal from the light-emitting control signal terminal EM. With the above setup, under the control of the signal of the light-emitting control signal terminal EM, the light-emitting control module 14 transmits the electrical signal of the first power supply voltage terminal Vdd to the second node N2, the drive transistor 10 transmits the electrical signal from the second node N2 (for example, the first power supply voltage signal Vdd) to the third node N3, and the light-emitting control module 14 can also transmit the electrical signal from the third node N3 (for example, the first power supply voltage signal Vdd) to a first electrode of the light-emitting device L1. Thus, it is realized that the pixel circuit 100 supplies a drive signal to the light-emitting device L1. The first power supply voltage signal can cooperate with a second power supply voltage signal Vss provided by a second power supply voltage signal terminal Vss connected with a second electrode of the light-emitting device L1 to drive the light-emitting device L1 to emit light normally.

Alternatively, in the first electrode and the second electrode of the light-emitting device L1, one electrode may be an anode and the other electrode may be a cathode. Embodiments of the present disclosure are described by taking the first electrode as an anode and the second electrode as a cathode as an example. On this basis, the potential of the first power supply voltage signal supplied from the first power supply voltage terminal VDD may be a high potential, and the potential of the second power supply voltage signal Vss supplied from the second power supply voltage terminal VSS may be a low potential.

In some embodiments, with continued reference to FIG. 5, the light-emitting control module 14 includes a fifth transistor and a sixth transistor. A gate of the fifth transistor is connected with the light-emitting control signal terminal EM, a first electrode of the fifth transistor is connected with the first power supply voltage terminal VDD, and a second electrode of the fifth transistor is connected with the first electrode of the drive transistor; a gate of the sixth transistor is connected with the light-emitting control signal terminal EM, a first electrode of the sixth transistor is connected with the second electrode of the drive transistor, a second electrode of the sixth transistor is connected with the first electrode of the light-emitting device, and the connection node is a fourth node N4.

In some embodiments, with continued reference to FIG. 5, the pixel circuit further includes a storage module 15 coupled to the first node N1 and the first supply voltage terminal VDD. The storage module 15 is configured to store the potential of the first node N1.

In some embodiments, with continued reference to FIG. 5, the storage module 15 includes a capacitor. A first plate of the capacitor is connected with the first power supply voltage terminal VDD, and the second plate is connected with a gate of the drive transistor.

In some embodiments, with continued reference to FIG. 5, the pixel circuit further includes a third reset module 133 connected to a fourth node N4. The third reset module 133 is connected with a third reset control signal terminal Re3, the fourth node N4, and a third initialization signal terminal Vinit3. The third reset module 133 is configured to, under the control of the third reset control signal, write the third initialization signal into the fourth node N4, i.e., the anode of the light-emitting element, and clear a pre-stored voltage inside the fourth node N4, and initialization is completed.

In some embodiments, with continued reference to FIG. 5, the second reset module 132 includes an eighth transistor. A gate of an eighth transistor is connected with the second reset control signal terminal Re2, a first electrode of the eighth transistor is connected with the second initialization signal terminal Vinit2, and a second electrode of the eighth transistor is connected with the first electrode of the drive transistor.

The third reset module 133 includes a seventh transistor. A gate of the seventh transistor is coupled with the third reset control signal terminal Re3, a first electrode of the seventh transistor is connected with the third initialization signal terminal Vinit3, and a second electrode of the seventh transistor is connected with the second electrode of the sixth transistor.

In some embodiments, the second reset control signal terminal Re2 and the third reset control signal terminal Re3 may receive the same gate signal, i.e., the second reset control signal terminal Re2 and the third reset control signal terminal Re3 are controlled in response to the same gate signal, and the gate signal is the third reset control signal. This can reduce the quantity of GOAs, which is beneficial to narrow the bezel of the display panel.

In some embodiments, the third reset control signal controls the second reset module 132 to be opened more times than the second scan control signal controls the compensation adjustment module 12 to be opened in the first display mode. It should be noted that the opening of the control module means that the control module is turned on under the control of the control signal.

It should be noted that the display apparatus in which the pixel circuit is located includes a plurality of display modes, such as a first display mode, a second display mode, etc. Herein, the display mode includes at least one refresh frame period, in which the pixel circuit normally refreshes and operates under the control of the gate control signal. The display mode may also include a hold frame, in which the light-emitting element continuously emits light, but only some of the modules in the pixel circuit are continue to be refreshed under the control of the gate control signal.

As shown in FIG. 7, T1 is a refresh frame period of the pixel circuit, T2 is a hold frame period of the pixel circuit, and the first display mode may include one refresh frame period and at least one display frame period. As shown in FIG. 7, during the refresh frame period T1, the third reset control signal controls the second reset module 132 to be opened once, and the second scan control signal controls the compensation adjustment module 12 to be opened once, that is, during the P2-P4 phase, the second scan control signal terminal Scan2 continuously outputs an effective level, the compensation adjustment module 12 is opened, and during the P5 phase, the third reset control signal terminal Re3 outputs an effective level, and the second reset module 132 is opened. During the hold frame period, the third reset control signal controls the second reset module 132 to be opened once, that is, during the P7 phase, only the third reset control signal terminal Re3 outputs an effective level, and the second reset module 132 is opened. Therefore, in the first display mode, the first display mode includes a refresh frame period and at least one display frame period, and the second reset module 132 is opened more times than the compensation adjustment module 12 is opened.

It should be noted that during the hold frame period, the second reset module 132 is opened and writes the initialization signal of the second initialization signal terminal Vinit2 into the N2 node, thereby ensuring that the potential difference of the first electrode of the drive transistor is not significant during the refresh frame and the hold frame, and improving the problem of flickering during frequency switching.

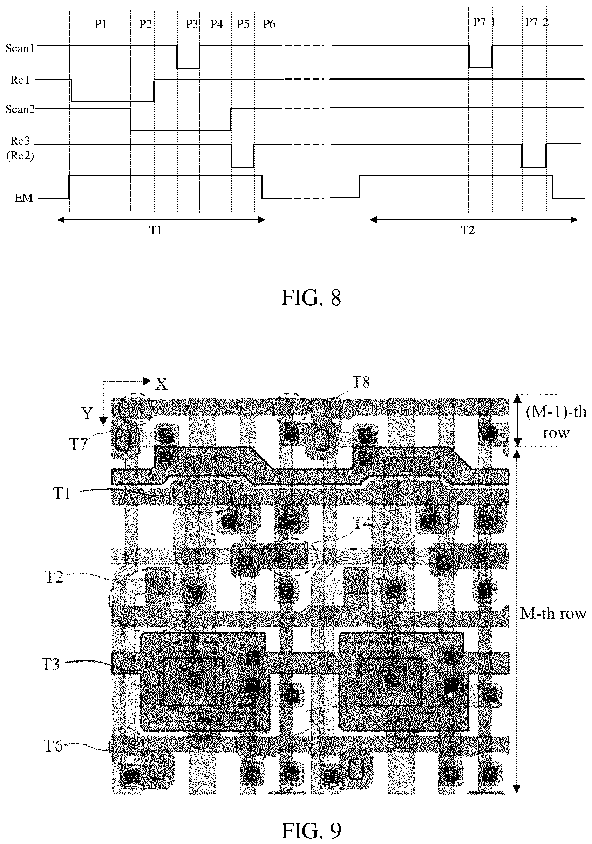

In some embodiments, the third reset control signal terminal Re3 and the first scan control signal terminal Scan1 may receive the same cascaded gate signal, i.e., the third reset control signal terminal Re3 and the first scan control signal terminal Scan1 are controlled in response to the same cascaded gate signal, and the gate signal is the third reset control signal. This can reduce the quantity of GOAs, which is beneficial to narrow the bezel of the display panel, as shown in FIG. 8.

In some embodiments, the first initialization signal and the second initialization signal may be the same initialization signal, i.e., the first initialization signal terminal Vinit1 and the second initialization signal terminal Vinit2 may receive the same initialization signal, e.g. may receive the first initialization signal. In this way, the quantity of signal lines can be reduced, which is beneficial to optimizing the wiring space.

It should be noted that the display panel is provided with a first initialization signal line for transmitting a first initialization signal, a second initialization signal line for transmitting a second initialization signal, a third initialization signal line for transmitting a third initialization signal, and the first initialization signal terminal Vinit1 for receiving the first initialization signal, the second initialization signal terminal Vinit2 for receiving the second initialization signal, and the third initialization signal terminal Vinit3 for receiving the third initialization signal. Based on this, the first reset control signal terminal Re1 in the pixel circuit 100 is connected with the first reset control signal line to receive the first reset control signal; the second reset control signal terminal Re2 is connected with the second reset control signal line to receive the second reset control signal; the third reset control signal terminal Re3 is connected with the third reset control signal line to receive the third reset control signal; the first initialization signal terminal Vinit1 is connected with the first initialization signal line to receive the initialization signal; the second initialization signal terminal Vinit2 is connected with the second initialization signal line to receive the initialization signal; the third initialization signal terminal Vinit 3 is connected with the third initialization signal line to receive the initialization signal.

It should be noted that the data writing module 11, the compensation adjustment module 12, the reset module, the light-emitting control module 14, and the storage module 15 have various configurations, which can be set up according to actual needs, which is not limited in the present disclosure.

Embodiments of the present disclosure provide a driving method of a pixel circuit as shown in FIG. 4 or FIG. 5. FIG. 7 is a timing diagram of each control signal in a driving method of the pixel drive circuit shown in FIG. 5. The display apparatus where the pixel circuit is located comprises a plurality of display modes, such as a first display mode, a second display mode, etc., wherein the display mode comprises at least one refresh frame period. During the refresh frame period, the pixel circuit normally refreshes and operates under the control of the gate control signal. The display mode may also include a hold frame period in which the light-emitting element continuously emits light, but only some of the modules in the pixel circuit are continue to be refreshed under the control of the gate control signal. As shown in FIG. 7, T1 is a refresh frame period of the pixel circuit, T2 is a hold frame period of the pixel circuit, and the first display mode may include one refresh frame period and at least one hold frame period. Herein, the one refresh frame period includes a reset phase, a data writing and holding phase, and a light-emitting phase P6 which are sequentially arranged.

In some embodiments, the data writing and holding phase includes a data writing phase P3 and a data holding phase P4 which are sequentially arranged. During the data writing phase P3, the first scan control signal terminal Scan1 and the second scan control signal terminal Scan2 output a low level, the first reset control signal terminal Re1, the second reset control signal terminal Re2, the third reset control signal terminal Re3 and the light-emitting control signal terminal EM output a high level, the data writing module 11 is turned on under the control of the first scan control signal, and transmits the data signal Vdata received at the data signal terminal Da to the second node N2, the drive transistor transmits the data signal Vdata from the second node N2 to the third node N3, and the compensation adjustment module 12, under the control of the second scan control signal, transmits the data signal Vdata from the third node N3 to the first node N1 for storage by the storage module. During the data holding phase P4, the second scan control signal terminal Scan2 outputs a low level, and the other control signal terminals output a high level. The data writing module 11 is turned off under the control of the first scan control signal, and the compensation adjustment module 12 continues to be turned on under the control of the second scan control signal to fully write the data signal in the circuit into the first node N1 until the potential of the node N1 becomes Vdata+Vth, and the drive transistor is turned off and the charging is stopped. Vth is the threshold voltage of the drive transistor. The data holding phase P4 can prolong the effective charging time, and the data signal is fully written to the first node N1 to compensate the threshold voltage, which is beneficial to high-frequency driving.

During the light-emitting phase P6, the light-emitting control signal terminal EM outputs a low level and the other control signal terminals output a high level. Under the control of the light-emitting control signal, the light-emitting control module 14 transmits the voltage signal provided by the first power supply voltage terminal VDD to the second node N2. The drive transistor turns on the second node N2 and the third node N3 according to the voltages of the first node N1 and the second node N2, and transmits the voltage signal to the light-emitting device to drive the light-emitting device to emit light. The formula for the output current of the drive transistor is as follows:

$$I= (\mu\ WCox/2L)\ (Vgs\text{-}Vth)\ 2$$

Herein, I is the output current of the drive transistor; $\mu$ is carrier mobility; Cox is the gate capacitance per unit area, W is the width of the drive transistor channel, L is the length of the drive transistor channel, Vgs is the gate-source voltage difference of the drive transistor, and Vth is the threshold voltage of the drive transistor.

According to the above formula for the output current of the drive transistor, the gate voltage Vdata+Vth and the source voltage Vdd (the first power supply voltage) of the drive transistor in the pixel drive circuit of the present disclosure are brought into the above formula to obtain the output current I = ($\mu$WCox/2L)(Vdata+Vth-Vdd-Vth)2 of the drive transistor in the pixel drive circuit of the present disclosure. Herein, VDD is the first power supply voltage of the first power supply voltage terminal VDD. Herein, the potential signal provided by the first power supply voltage terminal VDD is high level, and the potential signal provided by the second power supply voltage terminal VSS is low level.

In some embodiments, the reset phase includes a first reset phase P1 and a second reset phase P2 which are sequentially arranged. During the first reset phase P1, the first reset control signal terminal Re1 outputs a low level and the other control signal terminals output a high level. The first reset module is turned on under the control of the first reset control signal and transmits the first initialization signal to the first node N1. During the second reset phase P2, the first reset control signal terminal Re1 and the second scan control signal terminal Scan2 output a low level, the first scan control signal terminal Scan1, the second reset control signal terminal Re2, the third reset control signal terminal Re3 and the light-emitting control signal terminal EM output a high level, the first reset module continues to be turned on under the control of the first reset control signal, the compensation adjustment module 12 is turned on under the control of the second scan control signal, and transmits the first initialization signal to the first node N1, the second node N2 and the third node N3.

In some embodiments, the reset phase further includes a third reset phase P5 disposed after the data writing and holding phase. During the third reset phase P5, the second reset control signal terminal Re2 and the third reset control signal terminal Re3 output a low level, and the other control signal terminals output a high level. The second reset module 132 and the third reset module 133 are respectively turned on under the control of the second reset control signal and the third reset control signal. The second reset module 132 transmits the second initialization signal received at the second initialization signal terminal Vinit2 to the second node N2 and the third node N3. The third reset module 133 transmits the third initialization signal received at the third initialization signal terminal Vinit3 to the fourth node, i.e., the anode of the light-emitting element, and clear a pre-stored voltage inside it, and initialization is completed.

Continuing with reference to FIG. 7, a hold frame period T2 includes an adjustment phase P7. During the adjustment phase P7, the light-emitting device continues to emit light, the second reset control signal terminal Re2 and the third reset control signal terminal Re3 output low level, and the other control signal terminals output high level. Only the second reset module 132 and the third reset module 133 in the pixel circuit are turned on, and the second reset module 132 transmits the second initialization signal received at the second initialization signal terminal Vinit2 to the second node N2 to continuously reset the second node N2, thereby ensuring that the potential difference of the first electrode of the drive transistor is not significant during the refresh frame and the hold frame, and improving the problem of flickering during frequency switching. The third reset module 133 transmits the third initialization signal received at the third initialization signal terminal Vinit3 to the fourth node, so as to continuously reset the fourth node N4, that is, the anode, and improve the problem of low-frequency flickering.

In some embodiments, as shown in FIG. 8, the first scan control signal terminal Scan1 of the data writing module 11 and the third reset control signal terminal Re3 and the second reset control signal terminal Re2 of the third reset module and the second reset module may be controlled in response to the same cascaded gate signal, which may be the third reset control signal. In one refresh frame period T1, the same first reset phase P1, second reset phase P2, data writing phase P3, data holding phase P4, third reset phase P5 and light-emitting phase P6 as shown in FIG. 7 are included. The operation process of the pixel circuit in each phase can be referred to the description of the above-mentioned relevant parts and will not be described here.

Continuing with reference to FIG. 8, a hold frame period T2 includes a first adjustment phase P7-1 and a second adjustment phase P7-2. During the adjustment phases, the light-emitting device continues to emit light. During the first adjustment phase P7-1, the first scan control signal terminal Scan1 outputs a low level and the other control signal terminals output a high level.

Only the data writing module 11 in the pixel circuit is turned on under the control of the third reset control signal. It should be noted that during the hold frame period, the data signal terminal Data of the data writing module 11 may not output the data signal Vdata, or the data signal terminal Data may output the reference voltage to reset the N2 node, thereby ensuring that the potential difference of the first electrode of the drive transistor is not significant during the refresh frame and the hold frame, and improving the problem of flickering during frequency switching. During the second adjustment phase P7-2, the second reset control signal terminal Re2 and the third reset control signal terminal Re3 output a low level, and the other control signal terminals output a high level. Only the second reset module 132 and the third reset module 133 in the pixel circuit are turned on under the control of the third reset control signal. The second reset module 132 transmits the second initialization signal received at the second initialization signal terminal Vinit2 to the second node N2 to continuously reset the second node N2, thereby ensuring that the potential difference of the first electrode of the drive transistor is not significant during the refresh frame and the hold frame, and improving the problem of flickering during frequency switching. The third reset module 133 transmits the third initialization signal received at the third initialization signal terminal Vinit3 to the fourth node, so as to continuously reset the fourth node N4, that is, the anode, and improve the problem of low-frequency flickering.

On this basis, some embodiments of the present disclosure provide a display panel. The display panel includes a base substrate and a plurality of sub-pixels located on the base substrate, the sub-pixels are arranged in an array along a first direction X and a second direction Y. FIG. 2 is a schematic diagram of a planar structure of the display panel. At least one sub-pixel includes a circuit unit and a light-emitting device, the circuit unit includes a plurality of signal lines and a pixel circuit configured to output a corresponding current to the light-emitting device under the control of the control signal line. The pixel circuit includes a plurality of transistors, each of which includes a gate, a first electrode and a second electrode.

On a plane perpendicular to the display panel, the display panel may include a circuit layer disposed on the base substrate. A plurality of control signal lines extending in the first direction X are included in the circuit layer and are alternately arranged in the second direction Y. The first direction X and the second direction Y intersect with each other, for example, the first direction X and the second direction Y may be perpendicular to each other. The control signal line is connected with a gate of the transistor for providing a gate control signal. A gate of at least one transistor is located in a different film layer from the control signal line.

In some embodiments, the plurality of transistors include a drive transistor, a second transistor, and a fourth transistor. A first electrode of the second transistor is connected with a second electrode of the drive transistor, a second electrode of the second transistor is connected with a gate of the drive transistor, a second electrode of the fourth transistor is connected with a first electrode of the drive transistor, and a first electrode of the fourth transistor is connected with a data signal line.

The control signal lines include a first scan control signal line and a second scan control signal line. The first scan control signal line is connected with a gate of the fourth transistor for providing a first scan control signal. The second scan control signal line is connected with a gate of the second transistor for providing a second scan control signal. The first scan control signal line and the gate of the fourth transistor are located in different film layers.

In some embodiments, the second scan control signal line is located in a different film layer from the gate of the second transistor.

In some embodiments, the pixel circuit further includes a first transistor. A second electrode of the first transistor is connected with a gate of the drive transistor. The circuit layer also includes a plurality of first reset control signal lines extending in the first direction and alternately arranged in the second direction. The first reset control signal line is connected with a gate of the first transistor for providing a first reset control signal. The first reset control signal line and the gate of the first transistor are located in different film layers.

In some embodiments, when the control signal line and a gate are located in different film layers, the square resistance of the film layer in which the control signal line is located is smaller than the square resistance of the film layer in which the gate is located, i.e., the conductivity of the control signal line is greater than the conductivity of the gate, which is beneficial to improving the transmission efficiency of the control signal, thereby increasing the turn-on/turn-off efficiency of the transistor and facilitating high-frequency driving.

In some embodiments, the pixel circuit further includes a first transistor and an eighth transistor. A second electrode of the first transistor is connected with a gate of the drive transistor, and a second electrode of the eighth transistor is connected with a first electrode of the drive transistor.

The circuit layer also includes a plurality of first reset control signal lines and a plurality of third reset control signal lines extending in the first direction and alternately arranged in the second direction. The first reset control signal line is integrally structured with a gate of the first transistor for providing a first reset control signal, and the third reset control signal line is integrally structured with a gate of the eighth transistor for providing a third reset control signal.

In some embodiments, the pixel circuit further includes a fifth transistor, a sixth transistor, and a seventh transistor. A second electrode of the fifth transistor is connected with a first electrode of the drive transistor, a first electrode of the sixth transistor is connected with a second electrode of the drive transistor, and a second electrode of the seventh transistor is connected with a second electrode of the sixth transistor. The third reset control signal line and a gate of the seventh transistor are of an integral structure.

In some embodiments, the circuit layer further includes a plurality of light-emitting control signal lines extending in the first direction, the light-emitting control signal lines are integrally structured with gates of the fifth transistor and the sixth transistor. The second scan control signal line is integrally structured with a gate of the second transistor for providing a second scan control signal.

In some embodiments, the gate of the first transistor and the first reset control signal line, the gate of the second transistor and the second scan control signal line, the gate of the fourth transistor and the first scan control signal line, the gates of the fifth transistor and the sixth transistor and the light-emitting control signal line, and the gates of the seventh transistor and the eighth transistor and the third reset control signal line are all located in different film layers.

It should be noted that being located in different film layers can refer to a layer structure formed by using different film-forming processes to form a film layer for forming a specific graphic, and then patterning the film layer by a single patterning process using different masks. Depending on the specific graphic, the single patterning process includes multiple exposures, developing or etching processes, and the specific graphic in the formed layer structure may be continuous or discontinuous. That is, multiple elements, components, structures and/or parts located in "the same layer" are made of the same material and formed by a single patterning process, while the opposite is true in "different layers".

In some embodiments, the pixel circuit further includes a capacitor, the capacitor including a first plate and a second plate, the first plate and the gate of the drive transistor are of an integral structure, an orthographic projection of the second plate on the base substrate at least partially overlaps with an orthographic projection of the first plate on the base substrate. Adjacent second plates in a sub-pixel row arranged in the first direction are connected with each other.

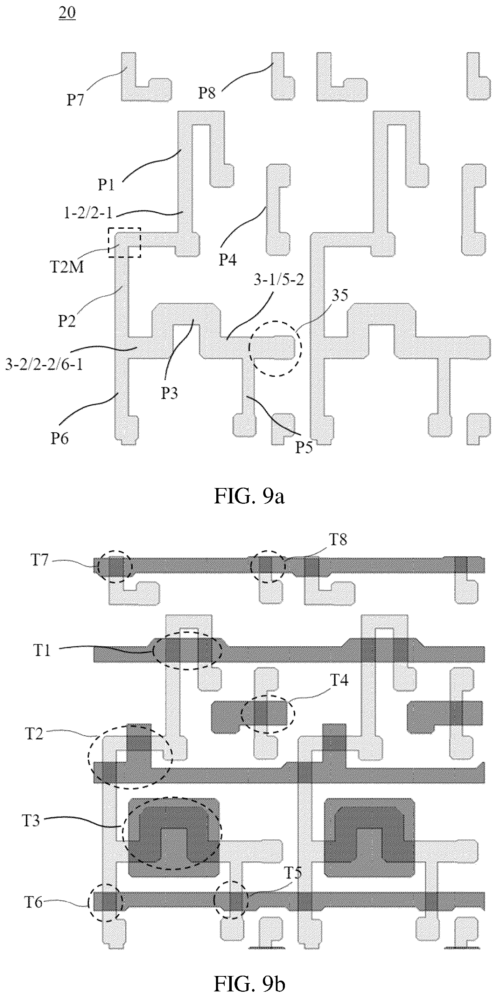

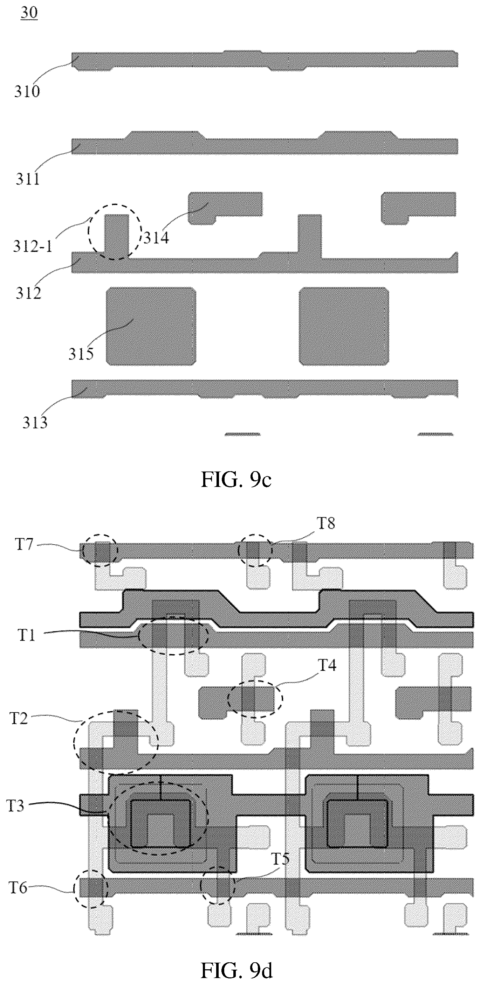

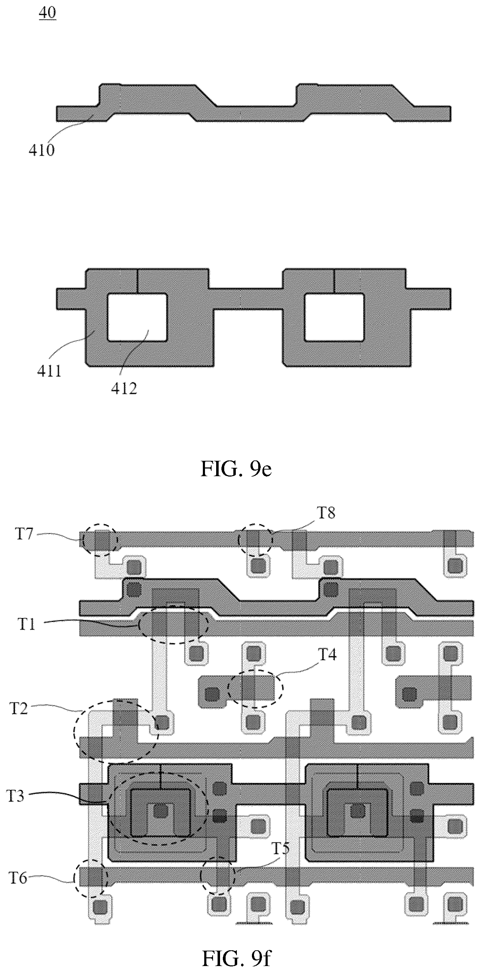

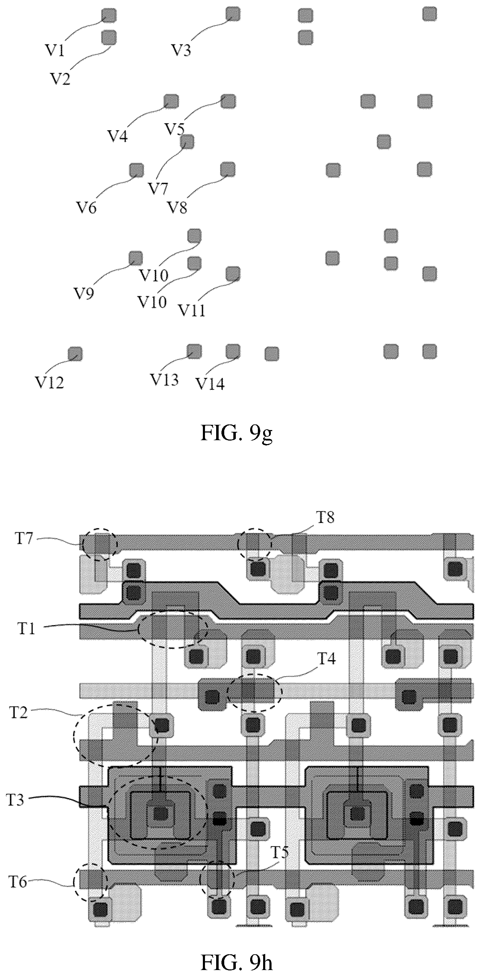

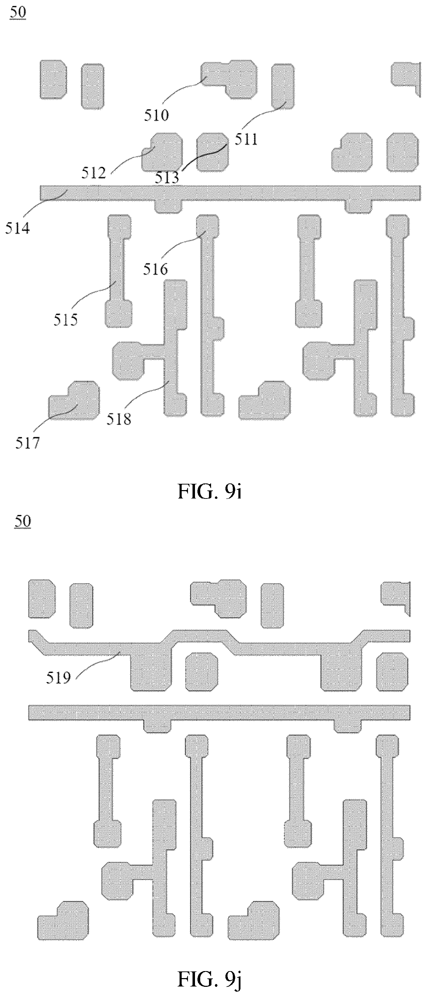

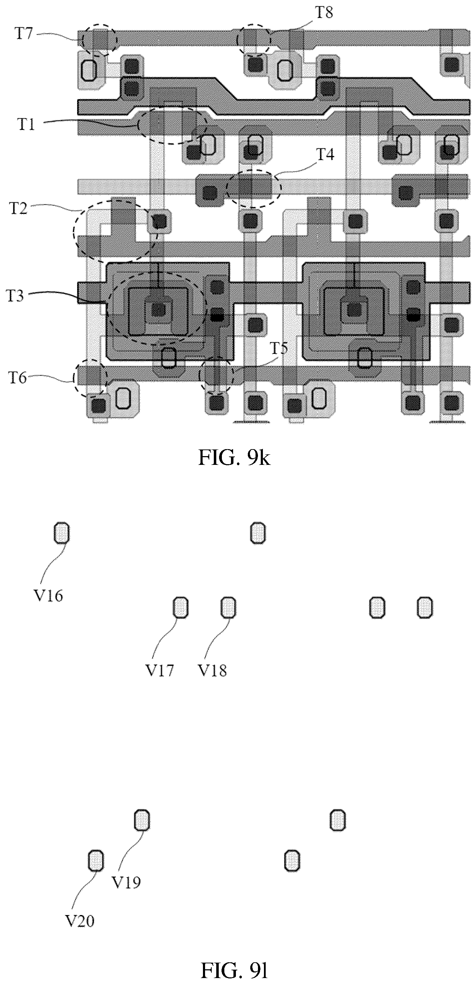

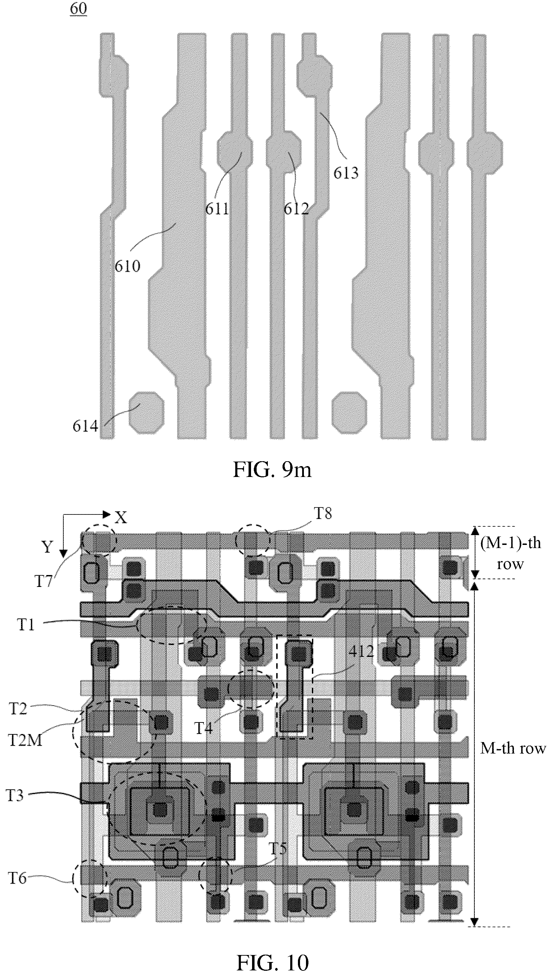

FIG. 9 to FIG. 13 are schematic diagrams of a structure of two adjacent pixel circuits in a M-th row in the display panel, wherein the structure of the pixel circuit of the M-th row is incomplete, and a part of the structure close to a (M+1)-th row is not shown, but a part of the structure of the pixel circuit of a (M-1)-th row is shown, which forms a complete pixel circuit with a part of the structure of the pixel circuit of the M-th row.

In some embodiments, as shown in FIG. 9, FIG. 9 is a schematic diagram of a structure of a display panel of the present disclosure which may be applied to pixel circuits as shown in FIG. 4 and FIG. 5. FIGs. 9a-9m are schematic diagrams of each single layer and sequentially stacked structure of the display panel of FIG. 9. The display panel may include a first semiconductor layer, a first conductive layer, a second conductive layer, a third conductive layer and a fourth conductive layer sequentially stacked on the base substrate, wherein an insulating layer may be arranged between adjacent film layers described above, and the insulating layer may include a first insulating layer, a second insulating layer, a third insulating layer, a fourth insulating layer and a fifth insulating layer, the first insulating layer is provided between the base substrate and the first semiconductor layer, the second insulating layer is provided between the first semiconductor layer and the first conductive layer, the third insulating layer is provided between the first conductive layer and the second conductive layer, the fourth insulating layer is provided between the second conductive layer and the third conductive layer, and the fifth insulating layer is provided between the third conductive layer and the fourth conductive layer.

The material of the insulating layer can be at least one of silicon nitride, silicon oxide and silicon oxynitride. The base substrate may include a glass substrate, a barrier layer and a polyimide layer sequentially stacked, and the barrier layer may be made of an inorganic material. Materials of the first conductive layer and the second conductive layer may be molybdenum, aluminum, copper, titanium, niobium, one of them or an alloy, or a molybdenum/titanium alloy or a laminate or the like. A material of the third conductive layer and the fourth conductive layer may include a metal material, for example, may be molybdenum, aluminum, copper, titanium, niobium, one of them or an alloy, or a molybdenum/titanium alloy or a laminate or the like, or may be a titanium/aluminum/titanium laminate.

In some embodiments, as shown in FIG. 9a, which is a schematic diagram of a structure of the display panel after a pattern of a first semiconductor layer 20 is formed. The pattern of the first semiconductor layer 20 may include active layers of the first transistor T1 to the eighth transistor T8. Specifically, the first active layer P1 of the first transistor T1, the second active layer P2 of the second transistor T2, the third active layer P3 of the third transistor T3, the fifth active layer P5 of the fifth transistor T5, the sixth active layer P6 of the sixth transistor T6 and the seventh active layer P7 of the seventh transistor T7 are of an interconnected integral structure. The first semiconductor layer further includes a fourth active layer P4 of the fourth transistor T4 and an eighth active layer P8 of the eighth transistor T8, the fourth active layer P4 and the eighth active layer P8 are respectively provided independently, i.e., orthographic projections of the active layers of the fourth transistor and the eighth transistor on the base substrate do not overlap an orthographic projection of the active layer of the above-mentioned integral structure on the base substrate. It should be noted that part of the seventh active layer P7 and the eighth active layer P8 shown in the drawing are part of the structure of a (M-1)-th row circuit unit.

The material of the first semiconductor layer (Poly) may include amorphous silicon, monocrystalline silicon, polysilicon, or metal oxide semiconductor material. The present disclosure takes a transistor of P-type low temperature polysilicon (LTPS) material as an example.

In some embodiments, the first active layer P1 may be in a "n" shape, the second active layer P2 may be in a "7" shape, the third active layer P3 may be in a shape of a Chinese character "几", and the fifth active layer P5, the sixth active layer P6, and the seventh active layer P7 may be in a "L" shape. The fourth active layer P4 and the eighth active layer P8 may be in a "1" shape.

In some embodiments, the active layer of each transistor may include a first region, a second region and a channel region located between the first region and the second region. In an exemplary embodiment, the second region 1-2 of the first active layer P1 simultaneously serves as the first region 2-1 of the second active layer P2, the first region 3-1 of the third active layer P3 simultaneously serves as the second region 5-2 of the fifth active layer P5, the second region 3-2 of the third active layer P3 simultaneously serves as the second region 2-2 of the second active layer P2 and the first region 6-1 of the sixth active layer P6, and the second region 6-2 of the sixth active layer P6 simultaneously serves as the second region 7-2 of the seventh active layer P7. Herein, the first region 3-1 of the third active layer P3 or the second region 5-2 of the fifth active layer P5 includes a first projection portion 35 extending in the first direction.

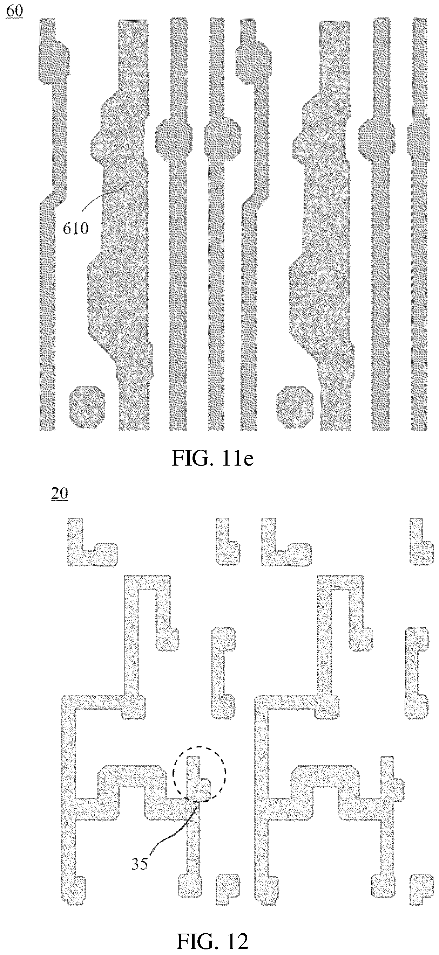

In some embodiments, as shown in FIG. 12, FIG. 12 is a schematic diagram of another structure of the display panel after a pattern of a first semiconductor layer is formed. The first region 3-1 of the third active layer P3 or the second region 5-2 of the fifth active layer P5 includes a first projection portion 35 extending in the second direction.

It should be noted that the setting of the first projection portion 35 is not limited to this, and there may be other ways of setting the first projection portion 35 as permitted by the space of the display panel according to the actual need.

In some embodiments, as shown in FIGs. 9b and 9c, FIGs. 9b and 9c are schematic diagrams of a structure of the display panel after a pattern of a first conductive layer is formed. The pattern of the first conductive layer 30 includes at least a third reset control signal line 310, a first reset control signal line 311, a second scan control signal line 312, a light-emitting control signal line 313, and a first plate 315. In some embodiments, the first conductive layer may be referred to as a first gate metal (GATE 1) layer.

As shown in conjunction with FIGs. 9 to 9c, main body portions of the third reset control signal line 310, the first reset control signal line 311, the second scan control signal line 312 and the light-emitting control signal line 313 extend in the first direction X. The first reset control signal line 311 and the second scan control signal line 312 in a M-th row circuit unit are located on a side of the first plate 315 of the present circuit unit away from a (M+1)-th row circuit unit, the first reset control signal line 311 is located on a side of the second scan control signal line 312 of the present circuit unit away from the first plate 315, the light-emitting control signal line 313 and the third reset control signal line 310 may be located on a side of the first plate 315 of the present circuit unit close to a (M+1)-th row circuit unit, and the third reset control signal line 310 is located on a side of the light-emitting control signal line 313 of the present circuit unit away from the first plate 315. It should be noted that the third reset control signal line 310 shown in the drawing is a signal line of a (M-1)-th row circuit unit.

In some embodiments, the first plate 315 may be in the shape of a rectangle, corners of which in shape of the rectangle may be provided with a chamfer, and there is an overlapped region between an orthographic projection of the first plate 315 on the base substrate and an orthographic projection of the third active layer P3 of the third transistor T3 on the base substrate. In an exemplary embodiment, the first plate 315 may simultaneously serve as a plate of the storage capacitor and a gate of the third transistor T3.

In some embodiments, a region where the first reset control signal line 311 overlaps with the first active layer P1 serves as a gate of the first transistor T1 with a double-gate structure. A region where the second scan control signal line 312 overlaps with the second active layer P2 serves as a gate of the second transistor T2 with a double-gate structure. The second scan control signal line 312 is provided with a gate block 312-1 protruding toward a side of the first reset control signal line 311. An orthographic projection of the gate block 312-1 on the base substrate and an orthographic projection of the second active layer P2 on the base substrate have an overlapped region to form a second transistor T2 with a double-gate structure. A region where the light-emitting control signal line 313 overlaps with the fifth active layer P5 serves as a gate of the fifth transistor T5, and a region where the light-emitting control line 313 overlaps with the sixth active layer P6 serves as a gate of the sixth transistor T6. A region where the third reset control signal line 310 overlaps with the seventh border layer P7 serves as a gate of the seventh transistor T7, and a region where the third reset control signal line 310 overlaps with the eighth border layer P8 serves as a gate of the eighth transistor T8.

In some embodiments, the first conductive layer 30 also includes a fourth gate block 314. In one pixel unit, the fourth gate block 314 is located between the first reset control signal line 311 and the second scan control signal line 312 in the second direction. A region where the fourth gate block 314 overlaps with the fourth active layer P4 serves as a gate of the fourth transistor T4.

In some embodiments, after the pattern of the first conducting layer is formed, the semiconductor layer may be metalized by using the first conducting layer as a shield. A region of the semiconductor layer, which is shielded by the first conducting layer, forms the channel regions of the first transistor T1 to the eighth transistor T8, and a region of the semiconductor layer, which is not shielded by the first conducting layer, is in conduction, that is, the first regions and the second regions of the first active layer to the eighth active layer are in conduction.

In some embodiments, as shown in FIGs. 9d and 9e, FIGs. 9d and 9e are schematic diagrams of a structure of the display panel after a pattern of a second conductive layer 40 is formed. The pattern of the second conductive layer includes at least a second initial signal line 410 and a second plate 411, as shown in FIGS. 9d and 9e, FIG. 9e is a plan schematic diagram of the second conductive layer in FIG. 9d. In an exemplary embodiment, the second conductive layer may be referred to as a second gate metal (GATE2) layer.

As shown in conjunction with FIGs. 9 to 9e, the main part of the main body portion of the second initial signal line 410 may extend in the first direction X, the second initial signal line 410 in the M-th row circuit unit is located on a side of the first reset control signal line 311 of the present circuit unit away from the (M+1)-th row circuit unit, and the second plate 411 is located between the second scan control signal line 312 and the light-emitting control signal line 313 of the present circuit unit, as another plate of the storage capacitor.

In some embodiments, a profile of second electrode plate 411 may be in the shape of a rectangle, corners of which in shape of the rectangle may be provided with a chamfer. There is an overlapped region between an orthographic projection of the second electrode plate 411 on the base substrate and an orthographic projection of the first electrode plate 315 on the base substrate, the first electrode plate 315 and the second electrode plate 411 form the storage capacitor of the pixel drive circuit. The second electrode plate 411 is provided with an opening 412, and the opening 412 may be located in the middle of the second electrode plate 411. The opening 412 may be rectangular and makes the second electrode plate 411 form an annular structure. The opening 412 exposes the third insulation layer covering the first electrode plate 315, and an orthographic projection of the first electrode plate 315 on the base substrate contains an orthographic projection of the opening 412 on the base substrate. In an exemplary embodiment, the opening 412 is configured to accommodate a first via subsequently formed, the first via is located in the opening 412 and exposes the first electrode plate 315, so that a second electrode of the first transistor T1 subsequently formed is connected with the first electrode plate 315.

In an exemplary embodiment, an electrode plate connection line is disposed between second electrode plates 411 of adjacent circuit units in the first direction X or an opposite direction of the first direction X, a first terminal of the electrode plate connection line is connected with the second electrode plate 411 of this circuit unit, and a second terminal of the electrode plate connection line extends along the first direction X or the opposite direction of the first direction X and is connected with a second electrode plate 411 of an adjacent circuit unit, that is, the electrode plate connection line is configured to enable second electrode plates of adjacent circuit units in a unit row to be connected with each other. In an exemplary embodiment, second plates of a plurality of circuit units in one unit row form an integrated structure connected with each other through the plate connection line, and the second plates with the integrated structure may be reused as a power supply signal line, thus ensuring that a plurality of second plates in one unit row have a same potential, which is conducive to improving uniformity of the panel, avoiding a poor display of the display substrate and ensuring a display effect of the display substrate.

In some embodiments, the second conductive layer further includes a shield (not shown in the figure). The second active layer includes a channel connection region T2M for connecting two channel regions of the second active layer to form a dual-gate transistor T2. An orthographic projection of the shield on the base substrate overlaps at least partially with an orthographic projection of the channel connection region T2M of the second transistor on the base substrate.

In some embodiments, as shown in FIGs. 9f and 9g, a fourth insulating layer covering the second conductive layer is formed for the display panel, and each circuit unit is provided with a plurality of vias, the plurality of vias include at least a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, a thirteenth via V13, and a fourteenth via V14, as shown in FIGs. 9f and 9g, FIG. 9g is a plan schematic diagram of the plurality of vias in FIG. 9f.

As shown in conjunction with FIG. 9 to FIG. 9g, the ninth via V9 is located in the opening 34 of the second electrode plate 32, and an orthographic projection of the ninth via V9 on the base substrate is located within a range of an orthographic projection of the opening 34 on the base substrate. The fourth insulating layer and the third insulating layer in the ninth via V9 are etched off to expose a surface of the first electrode plate 24. The ninth via V9 is configured such that a second electrode of the first transistor T1 subsequently formed is connected with the first plate 24 through the via.

In some embodiments, an orthographic projection of the first via V1 on the base substrate is located within a range of an orthographic projection of the seventh active layer on the base substrate. The fourth insulating layer, the third insulating layer and the second insulating layer in the first via V1 is etched away to expose a surface of the first region of the seventh active layer. The first via V1 is configured such that a first electrode of the seventh transistor T7 subsequently formed is connected with the seventh active layer through the via.

In some embodiments, an orthographic projection of the second via V2 on the base substrate is within the range of an orthographic projection of the second initial signal line 410 on the base substrate, the fourth insulating layer in the second via V2 is etched away to expose the surface of the second initial signal line 410, and the second via V2 is configured such that the first electrode of the subsequently formed seventh transistor T7 is connected to the second initial signal line 410 through the via.

In some embodiments, an orthographic projection of the third via V3 and the fourteenth via V14 on the base substrate is within the range of an orthographic projection of the eighth active layer on the base substrate, and the fourth insulating layer, the third insulating layer and the second insulating layer within the third via V3 and the fourteenth via V14 are etched away to expose the surfaces of the first region and the second region of the eighth active layer. The fourteenth via V14 is configured such that the first electrode of the subsequently formed eighth transistor T8 is connected with the eighth active layer through the via. The third via V3 is configured such that the subsequently formed third initialization signal line 613 is connected to the eighth active layer through the via.

In some embodiments, an orthographic projection of the fourth via V4 on the base substrate is within the range of an orthographic projection of the first active layer on the base substrate, and the fourth insulating layer, the third insulating layer and the second insulating layer within the fourth via V4 are etched away to expose the surface of the first region of the first active layer. The fourth via V4 is configured such that the first initialization signal line 611 formed subsequently is connected with the first active layer through the via.

In some embodiments, an orthographic projection of the fifth via V5 and the eighth via V8 on the base substrate is within the range of an orthographic projection of the fourth active layer on the base substrate, and the fourth insulating layer, the third insulating layer and the second insulating layer within the fifth via V5 and the eighth via V8 are etched away to expose the surfaces of the first region and the second region of the fourth active layer. The fifth via V5 is configured such that a data signal line formed subsequently is connected with the fourth active layer through the via, here the fifth via V5 is referred to as a data writing hole. The eighth via V8 is configured such that a second electrode of the subsequently formed fourth active layer is connected to the fourth active layer through the via. It can be understood that one end of the second electrode of the fourth active layer is connected with the fourth active layer through the eighth via V8 at one end and the other end is connected to the first projection portion 35 through the eleventh via V11.

In some embodiments, an orthographic projection of the sixth via V6 on the base substrate is located within a range of an orthographic projection of the second active layer on the base substrate. The fourth insulating layer, the third insulating layer, and the second insulating layer in the sixth via V6 are etched away to expose a surface of the first region of the second active layer (which is also the second region of the first active layer). The sixth via V6 is configured such that a second electrode of the first transistor T1 subsequently formed is connected with the first active layer through the via and a first electrode of the second transistor T2 subsequently formed is connected with the second active layer through the via.

In some embodiments, an orthographic projection of the seventh via V7 on the base substrate is within the range of an orthographic projection of the fourth gate block 314 on the base substrate, and the fourth and third insulating layers are etched away to expose the surface of the fourth gate block 314. The seventh via V7 is configured such that the first scan control signal line formed subsequently is connected with the fourth gate block 314 through the via.

In some embodiments, an orthographic projection of the tenth via V10 on the base substrate is located within a range of an orthographic projection of the second electrode plate 32 on the base substrate. The fourth insulating layer in the tenth via V10 is etched away to expose a surface of the second electrode plate 32. The tenth via V10 is configured such that the first power supply voltage line formed subsequently is connected with the second plate 32 through the via. In some embodiments, the tenth via V10 as a power supply via may be plural, and the plurality of tenth vias V10 may be sequentially arranged along the second direction Y to increase the reliability of the connection of the first power supply voltage line to the second plate 32. As shown in FIGS. 9f and 9g, the plurality of tenth vias V10 may be two.

In some embodiments, an orthographic projection of the thirteenth via V13 on the base substrate is within the range of an orthographic projection of the fifth active layer on the base substrate, and the fourth insulating layer, the third insulating layer and the second insulating layer within the thirteenth via V13 are etched away to expose the surface of the first region of the fifth active layer. The thirteenth via V13 is configured such that the first power supply voltage line formed subsequently is connected to the fifth active layer through the via.

In some embodiments, an orthographic projection of the twelfth via V12 on the base substrate is within the range of an orthographic projection of the sixth active layer on the base substrate, and the fourth insulating layer, the third insulating layer and the second insulating layer within the twelfth via V12 are etched away to expose the surface of the second region of the sixth active layer (also the second region of the seventh active layer). The twelfth via V12 is configured such that the second electrode of the subsequently formed sixth transistor T6 or the second electrode of the subsequently formed seventh transistor T7 is connected with the sixth active layer through the via.

In some embodiments, an orthographic projection of the eleventh via V11 on the base substrate is within the range of an orthographic projection of the first projection portion 35 on the base substrate, and the fourth insulating layer, the third insulating layer and the second insulating layer within the eleventh via V11 are etched away to expose the surface of the first projection portion 35. The eleventh via V11 is configured such that the second electrode of the fourth active layer formed subsequently is connected with the first projection portion 35 through the via.

In some embodiments, as shown in FIGS. 9h and 9i, FIGS. 9h and 9i are schematic diagrams of a structure of the display panel after a pattern of a third conductive layer 50 is formed. The third conductive layer includes at least a first connection electrode 512, a second connection electrode 511, a third connection electrode 510, a fourth connection electrode 515, a data connection electrode 513, an anode connection electrode 517, and a power supply connection electrode 518, as shown in FIGS. 9h and 9i, FIG.9i is a plan schematic diagram of the third conductive layer in FIG. 9h. In some embodiments, the third conductive layer may be referred to as a first source-drain metal (SD1) layer.

As shown in conjunction with FIGs. 9-9i, in some embodiments, a first end of the first connection electrode 512 is connected with a first region of the first active layer through the fourth via V4. In an exemplary embodiment, the first connection electrode 512 may serve as a first electrode of the first transistor T1 and the first connection electrode 512 is configured to be connected with the first initial signal line 611 subsequently formed.

In some embodiments, a first end of the second connection electrode 511 is connected with the second initialization signal line 410 through the second via V2, and a second end thereof is connected with the first region of the seventh active layer through the first via V1. In an exemplary embodiment, the second connection electrode 511 may serve as a first electrode of the seventh transistor T7 and the second connection electrode 511 is configured to be connected with the second initialization signal line 410 subsequently formed.

In some embodiments, a first end of the third connection electrode 510 is connected with the first region of the eighth active layer through the first via V1. In an exemplary embodiment, the third connection electrode 510 may serve as a first electrode of the eighth transistor T8 and the third connection electrode 510 is configured to be connected with the subsequently formed third initialization signal line 613.

In some embodiments, the fourth connection electrode 515 extends in the second direction Y, its first end is connected with the second region of the first active layer (also the first region of the second active layer) through the sixth via V6, and its second end is connected with the first plate 315 through the ninth via V9, so that the first plate 315, the second electrode of the first transistor T1 and the first electrode of the second transistor T2 have the same potential. In an exemplary embodiment, the fourth connection electrode 515 may serve as a second electrode of the first transistor T1 and a first electrode of the second transistor T2.

In some embodiments, the data connection electrode 513 is connected with the first region of the fourth active layer through the fifth via V5, and the data connection electrode 513 is configured to be connected with the data signal line 612 formed subsequently.

In some embodiments, the anode connection electrode 517 is connected with the second region of the sixth active layer (also the second region of the seventh active layer) through the twelfth via V12 so that the second electrode of the sixth transistor T6 and the second electrode of the seventh transistor T7 have the same potential. In an exemplary embodiment, the anode connection electrode 517 may serve as a second electrode of the sixth transistor T6 and a second electrode of the seventh transistor T7. In an exemplary embodiment, the anode connection electrode 517 is configured to be connected with an anode adapter block 614 subsequently formed.

In some embodiments, the power supply connection electrode 518 is connected with the second plate 411 and the first region of the fifth active layer through the tenth via V10 and the thirteenth via V13, respectively, so that the second plate 411 and the first electrode of the fifth transistor T5 have the same potential. In an exemplary embodiment, the power supply connection electrode 518 may serve as a first electrode of the fifth transistor T5. In an exemplary embodiment, the power supply connection electrode 518 is configured to be connected with the first power supply voltage line subsequently formed.

In some embodiments, the third conductive layer further includes a first scan control signal line 514 extending along the first direction X. The first scan control signal line 514 is connected with the fourth gate block 314 through the seventh via V7, and is configured to transmit a first scan control signal to the gate of the fourth transistor T4. An orthographic projection of the first scan control signal line 514 on the base substrate overlaps at least partially with an orthographic projection of the fourth gate block 314 on the base substrate, with the overlapping area accounting for 85% or more of the area of the fourth gate block. For example, the overlapping area accounts for 100% of the area of the fourth gate block, that is, the fourth gate block completely overlaps with an orthographic projection of the first scan control signal line on the base substrate. The overlapping area may also account for 90%, 95% or the like of the area of the fourth gate block, which is not limited herein.

In an exemplary embodiment, the square resistance of the third conductive layer where the first scan control signal line 514 is located is less than the square resistance of the first conductive layer where the gate of the transistor is located, so the conductivity of the first scan control signal line 514 is greater than the conductivity of the fourth gate block 314, and the signal transmission rate of the first scan control signal line 514 is greater than the signal transmission rate of other control signal lines located in the first conductive layer, thereby improving the turn-on/turn-off efficiency of the fourth transistor and facilitating high-frequency driving.

In some embodiments, the third conductive layer further includes a first adapter 516 that extends along the second direction Y. The first adapter 516 includes a first end, a third end, and a second end disposed between the first end and the third end, the first end thereof is connected with the second region of the fourth active layer through the eighth via V8, the third end thereof is connected with the second region of the eighth active layer through the fourteenth via V14, and the third end thereof is connected with the first projection portion 35 (the first region of the third active layer and the second region of the fifth active layer) through the eleventh via V11, so that the second electrode of the fourth transistor T4, the second electrode of the eighth transistor T8 and the first projection portion 35 have the same potential. In an exemplary embodiment, the first adapter 516 may serve as the second electrode of the fourth transistor T4 and the second electrode of the eighth transistor T8. By providing the first adapter 516 to be connected with the fourth active layer, the eighth active layer and the first projection portion 35 simultaneously, the present disclosure can reduce the quantity of vias and the quantity of adapter electrodes and save wiring space.

In some embodiments, as shown in FIG. 9j, the first connection electrode 512 may be replaced by a first connection electrode line 519 which extends in the first direction X. A first end of the first connection electrode line 519 is connected with the first region of the first active layer through the fourth via V4. In an exemplary embodiment, the first connection electrode line 519 is configured to be connected with the first initial signal line 611 subsequently formed thereby forming a grid structure and reducing the voltage drop of the signal line.

In some embodiments, as shown in FIGs. 9k and 9l, a fifth insulating layer covering the third conductive layer is formed for the display panel. A plurality of vias are provided in the fifth insulating layer of each circuit unit, and the plurality of vias include at least a sixteenth via V16, a seventeenth via V17, an eighteenth via V18, a nineteenth via and a twentieth via, as shown in FIGs. 9k and 9l, and FIG. 9l is a plan schematic diagram of the plurality of vias in FIG. 9k.

As shown in conjunction with FIGs. 9 to 9l, an orthographic projection of the sixteenth via V16 on the base substrate is within the range of an orthographic projection of the third connection electrode 510 on the base substrate, a first planarization layer in the sixteenth via V16 is removed to expose the surface of the third connection electrode 510, and the sixteenth via V16 is configured such that the subsequently formed third initialization signal line 613 is connected to the third connection electrode 510 through the via.

An orthographic projection of the seventeenth via V17 on the base substrate is within the range of an orthographic projection of the first connection electrode 512 on the base substrate. A first planarization layer in the seventeenth via V17 is removed to expose the surface of the first connection electrode 512. The seventeenth via V17 is configured such that the first initial signal line 611 formed subsequently is connected to the first connection electrode 512 through the via.

In some embodiments, an orthographic projection of an eighteenth via V18 on the base substrate is within the range of an orthographic projection of the data connection electrode 513 on the base substrate, a first planarization layer within the eighteenth via V18 is removed to expose the surface of the data connection electrode 513, and the eighteenth via V18 is configured such that the subsequently formed data signal line 612 is connected to the data connection electrode 513 through the via.

In some embodiments, an orthogonal projection of the nineteenth via V19 on the base substrate is within the range of an orthogonal projection of the power supply connection electrode 518 on the base substrate, and a first planarization layer in the nineteenth via V19 is removed to expose the surface of the power supply connection electrode 518, and the nineteenth via V19 is configured such that the subsequently formed first power supply voltage line 610 is connected with the power supply connection electrode 518 through this via.

An orthographic projection of the twentieth via V20 on the base substrate is within the range of an orthographic projection of the anode connection electrode 517 on the base substrate. A first planarization layer in the twentieth via V20 is removed to expose the surface of the anode connection electrode 517. The twentieth via V20 is configured such that the anode lap block 614 formed subsequently is connected to the anode connection electrode 517 through the via.

In some embodiments, as shown in FIG. 9m, FIG. 9m is a schematic diagram of a structure of the display panel after a pattern of a fourth conductive layer 60 is formed. The fourth conductive layer includes at least a first power supply voltage line 610 and a data signal line 612. FIG. 9m is a plan schematic diagram of the fourth conductive layer in FIG. 9. The fourth conductive layer may be referred to as a second source-drain metal (SD2) layer.

As shown in conjunction with FIGs. 9 to 9m, th first power supply voltage line 610 is disposed in each unit column. The first power supply voltage line 610 may extend along the second direction Y and is connected with the power supply connection electrode 518 through the nineteenth via V19. Since the power supply connection electrode 518 is connected with the second plate 411 and the first region of the fifth active layer through the tenth via V10 and the thirteenth via V13, respectively, the first power supply voltage line 610 is connected with the second plate 411 and the first region of the fourth active layer through the power supply connection electrode 518, so that the second plate 411 and the first electrode of the fourth transistor T4 have a same first power supply voltage Vdd.

In an exemplary embodiment, the active layer of the first transistor includes a channel connection region, an orthographic projection of the first power supply voltage line 610 on the base substrate overlaps at least partially an orthographic projection of the channel connection region of the first transistor on the base substrate, the node voltage of the channel connection region is stabilized by the first power supply voltage Vdd to reduce the leakage current of the dual-gate transistor T1 and further stabilize the gate voltage of the third transistor.

In some embodiments, the data signal line 611 are disposed in each unit column. The data signal line 611 may extend in the second direction Y, and the data signal line 611 is connected with the data connection electrode 513 through the eighteenth via V18. Because the data connection electrode 513 is connected with the first region of the fourth active layer through the eighteenth via V18, thus, it is achieved that the data signal line 611 is connected with the first region of the fourth active layer through the data connection electrode 513, so that a data signal is written into the fourth transistor T4.

In some embodiments, as shown in FIG. 9m, the fourth conductive layer further includes an anode lap block 614 disposed in at least a portion of the circuit unit. The anode lap block 614 is connected with the anode connection electrode 517 through the twentieth via V20. Since the anode connection electrode 517 is connected with the second region of the sixth active layer (also the second region of the seventh active layer) through the twelfth via V12, the anode lap block 614 is connected with the second region of the sixth active layer (also the second region of the seventh active layer) through the anode connection electrode 517.

In some embodiments, as shown in FIG. 9m, the fourth conductive layer further includes a first initialization signal line 611 and a third initialization signal line 613, and FIG. 9m is a plan schematic diagram of the fourth conductive layer in FIG. 9.

In some embodiments, the first initialization signal line 611 and the third initialization signal line 613 are disposed in each unit column and extend along the second direction Y.

In the exemplary embodiment, the first initialization signal line 611 is connected with the first connection electrode 512 through the seventeenth via V17. Since the first connection electrode 512 is connected with the first region of the first active layer through the fourth via V4, the first initialization signal line 611 is connected with the first region of the first active layer through the first connection electrode 512 to write the first initialization signal into the first transistor T1.

In yet another exemplary embodiment, the first initialization signal line 611 may be connected with the first connection electrode line 519 through the seventeenth via V17. Since the first connection electrode line 519 is connected with the first region of the first active layer through the fourth via V4, the first initialization signal line 611 is connected with the first region of the first active layer through the first connection electrode line 519 to write the first initialization signal to the first transistor T1. The first connection electrode line 519 extends along the first direction X and forms a grid structure with the first initialization signal line 611 extending along the second direction Y. This not only effectively reduces the resistance of the first initialization signal line, reduces the voltage drop of the first initialization signal and accelerates the reset rate, but also effectively improves the uniformity of the first initialization signal in the display substrate, which is beneficial to the high-frequency display of the picture quality.

In the exemplary embodiment, the third initialization signal line 613 is connected with the third connection electrode 510 through the sixteenth via V16. Since the third connection electrode 510 is connected with the first region of the eighth active layer through the first via V1, the third initialization signal line 613 is connected with the first region of the eighth active layer through the third connection electrode 510 to write the third initialization signal to the eighth transistor T8.

In some embodiments, the first initialization signal line 611 connected with a same column of pixel circuits is located between the first power supply voltage line 610 and the data signal line 612, and the third initialization signal line 613 is located on a side of the data signal line 612 away from the first initialization signal line 611. Therefore, in the display panel, the first power supply voltage line 610 and the data signal line 612 are spaced apart by the first initialization signal line 611 and the third initialization signal line 613, thereby effectively shielding the signal crosstalk between the first power supply voltage and the data voltage and facilitating the improvement of the display effect.

In some embodiments, an orthographic projection of at least part of the first adapter 516 on the base substrate is within the range of an orthographic projection of the data signal line 612 on the base substrate, with the overlapping area accounting for more than 90% of the area of the first adapter, which can make full use of the layout space, avoid the influence on the light transmittance due to the provision of the data signal line 612, and improve the display effect.

In some embodiments, an orthographic projection of the fourth connection electrode 515 on the base substrate is within the range of an orthographic projection range of the first power supply voltage line 610 on the base substrate, so that not only the first power supply voltage line 610 can effectively shield the influence of the first initialization signal line 611 and the third initialization signal line 613 on the key nodes in the pixel drive circuit, but also the layout space can be fully utilized to avoid the influence on the light transmittance due to the provision of the first power supply voltage line 610 and improve the display effect.

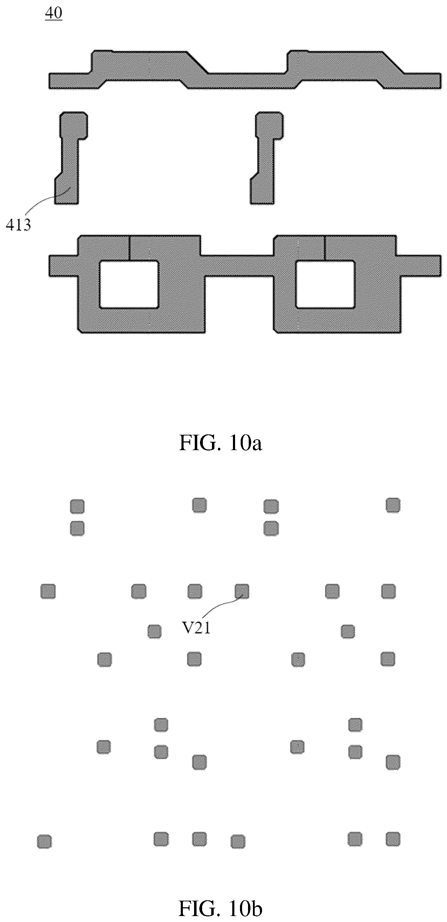

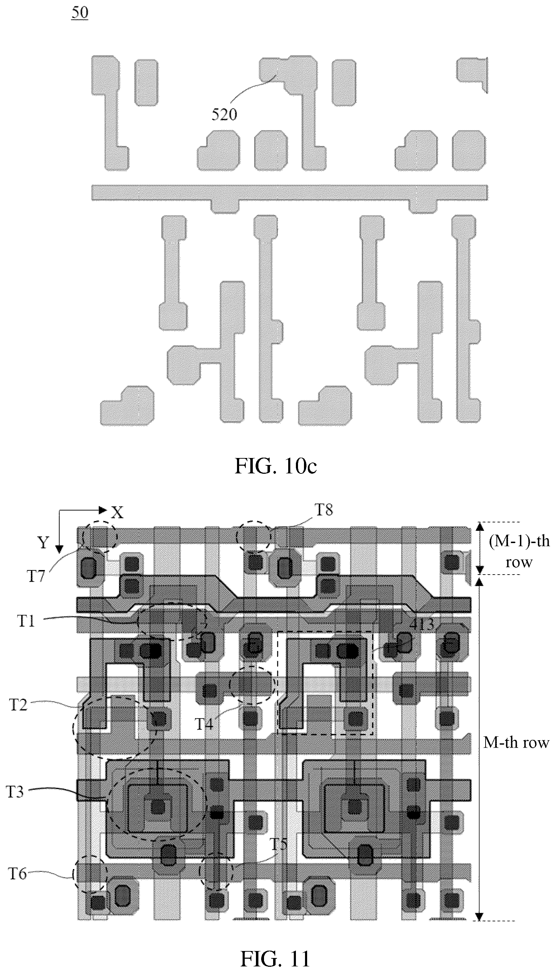

In some exemplary embodiments referring to FIGs. 10-10c, the second conductive layer 40 further includes a shield 413 extending in the second direction Y and including a first end and a second end. An orthographic projection of a twenty-first via V21 on the base substrate falls within an orthographic projection of the first end of the shield 413 on the base substrate. The fourth insulating layer in the twenty-first via V21 is removed so as to expose the first end of the shield 413. The first end of the shield 413 is connected with the third initialization signal line 613 formed subsequently through the via. The third conductive layer 50 also includes a third connection electrode line 520 including a first end, a third end and a second end connecting the first end and the third end. A portion between the second end and the third end of the third connection electrode line 520 extends in the second direction Y, and a portion between the first end and the second end of the third connection electrode line 520 extends in the first direction X. The first end of the third connection electrode line 520 is connected with the first region of the eighth active layer through the third via V13, the third end of the third connection electrode line 520 is connected with a first end of the shield 413 through the twenty-first via V21, and the third connection electrode line 520 is configured to be connected with the subsequently formed third initialization signal line 613. The third initialization signal line 613 is connected with the second end of the third connection electrode line 520 through the sixteenth via V16, the third end of the third connection electrode line 520 is connected with the first end of the shield 413 through the twenty-first via V21, and the third initialization signal line 613 is configured to connect the third initialization signal to the shield 413 and the eighth transistor T8 through the third connection electrode line 520.

In some embodiments, an orthographic projection of the third connection electrode line 520 and a portion of the shield 413 on the base substrate overlaps with an orthographic projection of a portion of the third initialization signal line 613 on the base substrate, so that the layout space can be fully utilized, the influence on the light transmittance due to the provision of the third connection electrode line 520 and the shield 413 can be avoided, and the display effect can be improved.

The second active layer includes a channel connection region T2M for connecting two channel regions of the second active layer to form a dual-gate transistor T2. An orthographic projection of a portion of the channel connection region T2M on the base substrate falls within an orthographic projection of a second end of the shield 413 on the base substrate. Since the shield 413 is connected with the third initialization signal, the node voltage of the channel connection region T2M is stabilized by the third initialization signal, thereby reducing the leakage current of the double-gate transistor T2 and further stabilizing the gate voltage of the third transistor.

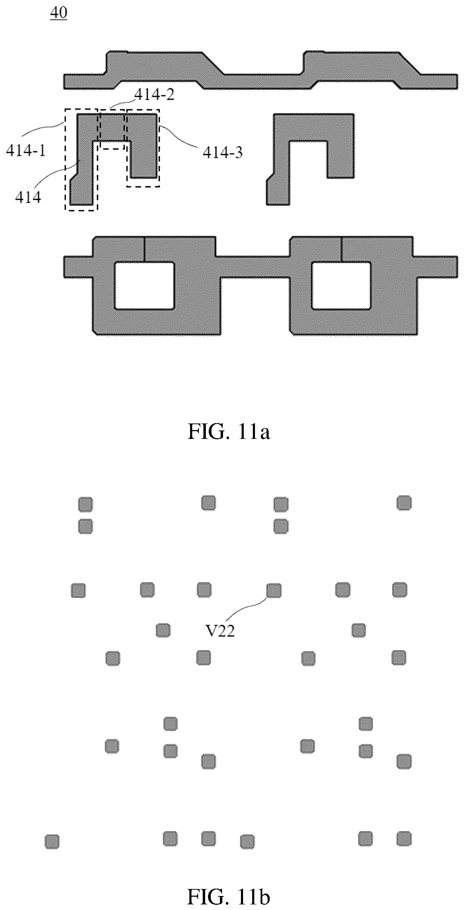

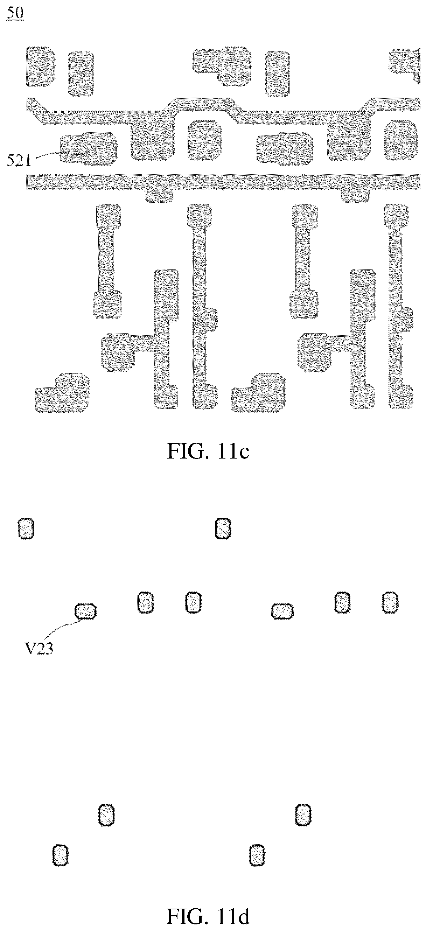

In some exemplary embodiments, referring to FIGs. 11-11e, the second conductive layer 40 further includes a shield 414 including a first portion 414-1 and a third portion 414-3 extending in the second direction Y, and a second portion 414-2 extending in the first direction X and connected with the first portion 414-1 and the third portion 414-3. An orthographic projection of the twenty-second via V22 on the base substrate falls within an orthographic projection of the second portion 414-2 on the base substrate, and the fourth insulating layer in the twenty-second via V22 is removed so as to expose a portion of the second portion 414-2, the second portion 414-2 is connected with the subsequently formed first power supply voltage line 610 through the via. The third conductive layer 50 also includes a fifth connection electrode 521 connected with the second portion 414-2 of the shield through the twenty-second via V22, and configured to be connected with the first power supply voltage line 610 formed subsequently. An orthographic projection of a twenty-third via V23 on the base substrate falls within an orthographic projection of the fifth connection electrode 521 on the base substrate, and the fifth insulating layer in the twenty-third via V23 is removed to expose a portion of the fifth connection electrode 521, the fifth connection electrode 521 is connected with the first power supply voltage line 610 formed subsequently through the via. The first power supply voltage line 610 is connected with the fifth connection electrode 521 through the twenty-third via V23, and the fifth connection electrode 521 is connected with the second portion 414-2 of the shield through the twenty-second via V22. The first power supply voltage line 610 is configured such that the first power supply voltage is connected to the shield 414 through the fifth connection electrode 521.

In some embodiments, an orthographic projection of the fifth connection electrode 521 on the base substrate overlaps at least partially with an orthographic projection of the shield 414 on the base substrate, with the overlapping area of more than 90% of the area of the fifth connection electrode 521. An orthographic projection of the third portion 414-3 of the shield on the base substrate is within the range of an orthographic projection of the first power supply voltage line 610 on the base substrate, so that the layout space can be fully utilized, the influence on the light transmittance due to the provision of the fifth connection electrode 521 and the shield 414 can be avoided, and the display effect can be improved.

The second active layer includes a channel connection region T2M for connecting two channel regions of the second active layer to form a dual-gate transistor T2. An orthographic projection of a portion of the channel connection region T2M on the base substrate is within the range of an orthographic projection of the first portion 414-1 of the shield on the base substrate. Since the shield 414 is connected with the first power supply voltage, the node voltage of the channel connection region T2M is stabilized by the first power supply voltage, the leakage current of the double-gate transistor T2 is reduced, and the gate voltage of the third transistor is further stabilized. An orthographic projection of a portion of the second region of the first active layer on the base substrate is within the range of an orthographic projection of the third portion 414-3 of the shield on the base substrate. Since the shield 414 is connected with the first power supply voltage, the voltage of the second region of the first active layer is stabilized by the first power supply voltage, the leakage current of the double-gate transistor T1 is reduced, and the gate voltage of the third transistor is further stabilized. A schematic diagram of the nodes N5 and N6 of the channel connection region of the dual-gate transistors T1 and T2 stabilizing the dual-gate nodes with a constant voltage signal is shown in FIG. 6.

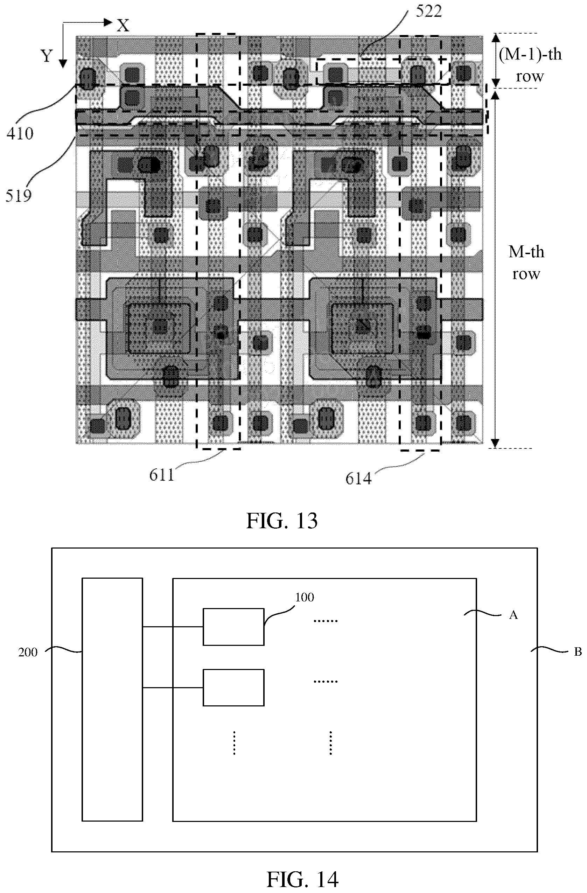

In some embodiments, as shown in FIG. 13, the first initialization signal line 611 and the second initialization signal line 410 may simultaneously form a grid structure.

In an exemplary embodiment, as shown in FIG. 13, the first initialization signal line 611 may also be disposed at intervals in unit columns along the first direction X, for example, the first initialization signal line 611 may be disposed in a N-th unit column, a (N+2)-th unit column, a (N+4)-th unit column, etc. The first initialization signal line 611 is connected with the first connection electrode line 519 through the seventeenth via V17. Since the first connection electrode line 519 is connected with the first region of the first active layer through the fourth via V4, the first initialization signal line 611 is connected with the first region of the first active layer through the first connection electrode line 519 to write the first initialization signal to the first transistor T1. The first connection electrode line 519 extends in the first direction X and forms a grid structure with the first initialization signal line 611 extending in the second direction Y to further reduce the resistance and voltage drop of the signal line. In an exemplary implementation, a quantity of unit columns spaced between adjacent first initial signal lines 611 is not particularly required and may be set as required, and the present disclosure is not limited herein.

In an exemplary embodiment, as shown in FIG. 13, the fourth conductive layer 60 may further include a second sub-initialization signal line 614 extending in the second direction Y and disposed at intervals in unit columns in the first direction X. For example, the second sub-initialization signal line 614 may be disposed in a (N-1)-th unit column, a (N+1)-th unit column, a (N+3)-th unit column, etc. The second sub-initialization signal line 614 is provided in a unit column at substantially the same position as the first initialization signal line 611. The third conductive layer 50 may also include a second initialization adapter 522 to which the second sub-initialization signal line 614 is connected through a via, and the second initialization adapter 522 is connected to the second initialization signal line 410 and the first region of the seventh active layer through a via, thereby enabling the connection of the second initialization signal line 410 to the first region of the seventh active layer through the second initialization adapter 522 to write the second initialization signal to the seventh transistor T7. The second sub-initialization signal line 614 extends in the second direction Y and forms a grid structure with the second initialization signal line 410 extending in the first direction X to further reduce the resistance and voltage drop of the signal line. In an exemplary implementation, a quantity of unit columns spaced between adjacent second sub-initialization signal lines 614 is not particularly required and may be set as required, and the present disclosure is not limited herein.

In some embodiments, it may only be the first initialization signal line 611 or the second initialization signal line 410 that forms the grid structure.

So far, as shown in FIG. 14, embodiments of the present disclosure also provide a display apparatus. The display apparatus includes a display region A and at least one peripheral region B adjacent to the display region, a plurality of pixel circuits as shown in FIG. 4 or FIG. 5 are provided in the display region, and a gate drive circuit 200 is provided in the peripheral region. The gate drive circuit is used for supplying corresponding gate signals to the reset control signal terminal, the first scan control signal terminal Scan1 and the second scan control signal terminal Scan2 of the pixel circuit.

In the specific implementation process, one of the schematic diagrams of the distribution of the display region A and the peripheral region B may be as shown in FIG. 14, and the display region A and the peripheral region B may be divided according to the actual application needs, which will not be described in detail here.

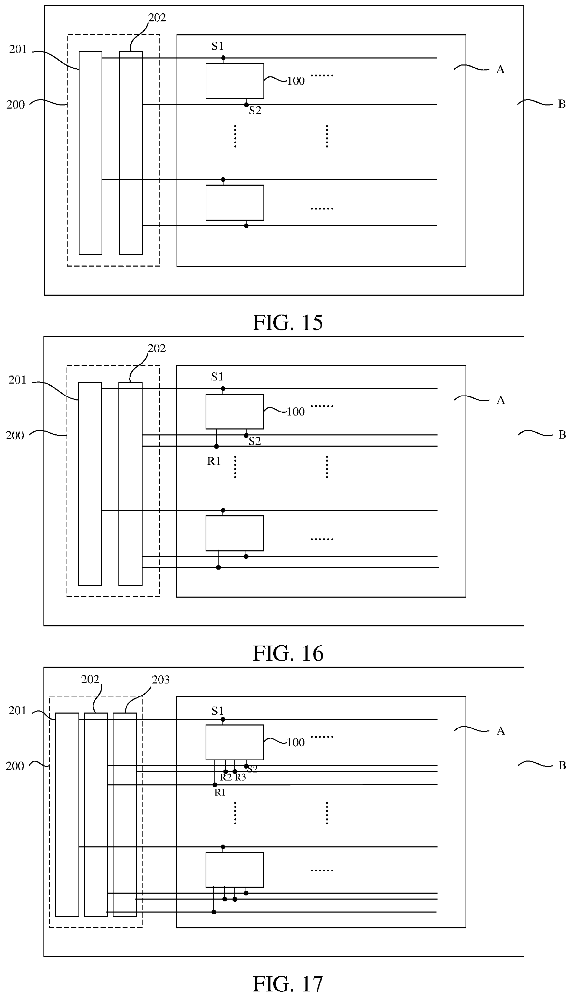

In some embodiments, as shown in FIG. 15, the gate drive circuit 200 includes a first gate drive unit 201 connected with a first scan control signal terminal S1 of at least one row of pixel circuits and a second gate drive unit 202 connected with a second scan control signal terminal S2 of at least one row of pixel circuits. The first gate drive unit is configured to provide a first scan control signal of a first frequency to the first scan control signal terminal; the second gate drive unit is configured to provide a second scan control signal of a second frequency to the second scan control signal terminal, the second frequency is equal to the first frequency in one refresh frame period, and the effective duration of the second scan control signal is longer than the effective duration of the first scan control signal. Thus, the second scan control signal having a relatively large effective duration ensures that the data signal supplied from the data signal terminal Data is sufficiently written into a gate of the drive transistor T3, thereby ensuring the driving capability of the pixel circuit.

In some embodiments, as shown in FIG. 16, the second gate drive unit 202 is further connected with the first reset control signal terminal Re1 of at least one row of pixel circuits, and the first reset control signal terminal Re1 and the second scan control signal terminal S2 of the same row of pixel circuits are respectively connected with different stage output terminals of the second gate drive unit 202, wherein, in one refresh frame period, the time when the first reset control signal terminal Re1 receives the effective level of the second scan control signal is earlier than the time when the second scan control signal terminal receives the effective level of the second scan control signal.

In some embodiments, as shown in FIG. 17, the gate drive circuit further includes a first reset drive unit 203 connected with a second reset control signal terminal and a third reset control signal terminal of at least one row of pixel circuits, the second reset control signal terminal and the third reset control signal terminal of the same row of pixel circuits are connected with the same stage output terminal of the first reset drive unit, the first reset drive unit is configured to provide a third reset control signal of a third frequency to the same stage output terminal, wherein, in the first display mode, the third frequency is greater than the first frequency, and the effective duration of the third reset control signal is equal to the effective duration of the first scan control signal.

In some embodiments, not shown schematically, the gate drive circuit includes a first reset drive unit connected with a first scan control signal terminal, a second reset control signal terminal and a third reset control signal terminal of at least one row of pixel circuits, the second reset control signal terminal and the third reset control signal terminal of the same row of pixel circuits are connected with the same stage output terminal of the first reset drive unit, the first scan control signal terminal and the second initialization signal terminal of the same row of pixel circuits are connected with different stage output terminals of the first reset drive unit, and the time when the first scan control signal terminal receives the effective level of the third reset control signal is earlier than the time when the second reset control signal terminal receives the effective level of the third reset control signal.

Since the principle of solving the problem of the display apparatus is similar to that of the pixel circuit mentioned above, the implementation of the display apparatus can be referred to the implementation of the aforementioned pixel circuit section, any repetitive details will not be reiterated.

In the specific implementation process, the display apparatus provided by an embodiment of the present disclosure can be a small-size AMOLED, so that the data writing time per line can be relatively long, and the first electrode of the drive transistor can be reset through a larger constant reset signal provided by the data signal terminal Data. Accordingly, the display apparatus may be any product or component having a display function such as a watch, a bracelet, a mobile phone, etc. Other essential components included in the display apparatus which should be understood to be included in the display apparatus by those of ordinary skill in the art will not be described repeatedly herein, and should not be taken as a limitation on the present disclosure.

Although preferred embodiments of the present disclosure have been described, those skilled in the art may make additional changes and modifications to these embodiments once the underlying inventive concepts are known. Therefore, the appended claims are intended to be interpreted to encompass preferred embodiments as well as all changes and modifications falling within the scope of the present disclosure.

Apparently, various modifications and variations to the present disclosure may be made by those skilled in the art without departing from the spirit and scope of the present disclosure. Thus, if these modifications and variations to the present disclosure fall within the scope of the claims of the present disclosure and their equivalent techniques, the present disclosure is intended to include these modifications and variations.

**Claims**

1. A pixel circuit, comprising:

   a drive transistor having a gate, a first electrode and a second electrode connected with a first node, a second node and a third node, respectively, wherein the drive transistor is configured to provide a drive signal to a light-emitting device;
   a data writing module connected with a first scan control signal terminal, a data signal terminal and the second node, wherein the data writing module is configured to write a data signal provided by the data signal terminal to the second node under control of a first scan control signal provided by the first scan control signal terminal;
   a compensation adjustment module connected with a second scan control signal terminal, the first node, and the third node, wherein the compensation adjustment module is configured to control a conduction or disconnection between the first node and the third node under control of a second scan control signal provided by the second scan control signal terminal;
   a first reset module connected with a first reset control signal terminal, the first node and a first initialization signal terminal; wherein in one refresh frame period, when the compensation adjustment module is turned off, the first reset module is configured to write a first initialization signal provided by the first initialization signal terminal into the first node under control of a first reset control signal; when the compensation adjustment module is turned on, the first reset module is configured to write the first initialization signal provided by the first initialization signal terminal into the first node and the third node under control of the first reset control signal.

2. The pixel circuit according to claim 1, wherein in one refresh frame period, the time for which the second scan control signal controls the compensation adjustment module to be turned on is greater than or equal to four times the time for which the first scan control signal controls the data writing module to be turned on.

3. The pixel circuit according to claim 2, wherein in one refresh frame period, after the data writing module is turned off under control of the first scan control signal, the compensation adjustment module continues to be turned on under control of the second scan control signal, the time for which the second scan control signal controls the compensation adjustment module to continue to be turned on is greater than or equal to three times the time for which the first scan control signal controls the data writing module to be turned on.

4. The pixel circuit according to claim 1, wherein the first reset control signal terminal and the second scan control signal terminal are controlled in response to a same cascaded gate signal, and the cascaded gate signal is the second scan control signal.

5. The pixel circuit according to claim 1, wherein the first reset module comprises a first transistor, the gate of the first transistor is connected with the first reset control signal terminal, the first electrode of the first transistor is connected with the first initialization signal terminal, and the second electrode of the first transistor is connected with the gate of the drive transistor;

   the compensation adjustment module comprises a second transistor, a gate of the second transistor is connected with the second scan control signal terminal, a first electrode of the second transistor is connected with the gate of the drive transistor, and a second electrode of the second transistor is connected with the second electrode of the drive transistor;
   the data writing module comprises a fourth transistor, a gate of the fourth transistor is connected with the first scan control signal terminal, a first electrode of the fourth transistor is connected with the data signal terminal, and a second electrode of the fourth transistor is connected with the first electrode of the drive transistor.

6. The pixel circuit according to claim 1, wherein the pixel circuit further comprises a second reset module connected with a second reset control signal terminal, a second initialization signal terminal and the second node and/or the third node; the second reset module is configured to write a second initialization signal provided by the second initialization signal terminal to at least one of the second node and the third node under the control of the second reset control signal.

7. The pixel circuit according to claim 6, wherein the pixel circuit further comprises a light-emitting control module, the light-emitting control module comprises a fifth transistor and a sixth transistor; a gate of the fifth transistor is connected with a light-emitting control signal terminal, a first electrode of the fifth transistor is connected with a first power supply voltage terminal, and a second electrode of the fifth transistor is connected with the first electrode of the drive transistor; a gate of the sixth transistor is connected with the light-emitting control signal terminal, a first electrode of the sixth transistor is connected with the second electrode of the drive transistor, a second electrode of the sixth transistor is connected with a first electrode of the light-emitting device, and the connecting node is a fourth node; the light-emitting control module is configured to control a conduction or disconnection between the first power supply voltage terminal and the second node, and to control a conduction or disconnection between the third node and the fourth node under a light-emitting control signal provided by the light-emitting control signal terminal, and to provide a drive signal generated by the drive module to the light-emitting device.

8. The pixel circuit according to claim 7, wherein the pixel circuit further comprises a third reset module connected with a third reset control signal terminal, the fourth node and a third initialization signal terminal; the third reset module is configured to write a third initialization signal into the fourth node under control of the third reset control signal.

9. The pixel circuit according to claim 8, wherein the second reset control signal terminal and the third reset control signal terminal are controlled in response to a same gate signal, and the gate signal is the third reset control signal.

10. The pixel circuit according to claim 9, wherein, in a first display mode, a quantity of times the third reset control signal controls the second reset module to be turned on is greater than a quantity of times the second scan control signal controls the compensation adjustment module to be turned on.

11. The pixel circuit according to claim 9, wherein the third reset control signal terminal and the first scan control signal terminal are controlled in response to a same cascaded gate signal, and the gate signal is the third reset control signal.

12. The pixel circuit according to claim 8, wherein the second reset module comprises an eighth transistor, a gate of the eighth transistor is connected with the second reset control signal terminal, a first electrode of the eighth transistor is connected with the second initialization signal terminal, and a second electrode of the eighth transistor is connected with the first electrode of the drive transistor;

the third reset module comprises a seventh transistor, a gate of the seventh transistor is connected with the third reset control signal terminal, a first electrode of the seventh transistor is connected with the third initialization signal terminal, and a second electrode of the seventh transistor is connected with the second electrode of the sixth transistor;
the pixel circuit further comprises a storage module, wherein the storage module comprises a first plate and a second plate, wherein the first plate is connected with the first power supply voltage terminal, and the second plate is connected with the gate of the drive transistor; the storage module is configured to store a potential of the first node.

13. A driving method of a pixel circuit, wherein the pixel circuit comprises:

a drive transistor having a gate, a first electrode and a second electrode connected with a first node, a second node and a third node, respectively; a data writing module connected with a first scan control signal terminal, a data signal terminal and the second node; a compensation adjustment module connected with a second scan control signal terminal, the first node, and the third node;
the pixel circuit operates in a plurality of display modes, wherein in a first display mode, the first display mode comprises one refresh frame period and at least one hold frame period, a refresh frame comprises a data writing and holding phase and a light-emitting phase;
the data writing and holding phase comprises a data writing phase and a data holding phase, during the data writing phase, the data writing module is turned on under control of the first scan control signal to transmit a data signal received at the data signal terminal to the first node, the drive transistor transmits a data signal from the second node to the third node, and the compensation adjustment module transmits a data signal of the third node to the first node under control of the second scan control signal; during the data holding phase, the data writing module is turned off under the control of the first scan control signal, and the compensation adjustment module continues to be turned on to fully write the data signal in a circuit into the first node;

during the light-emitting phase, the light-emitting control module transmits a voltage signal provided by a first power supply voltage terminal to the second node under control of a light-emitting control signal, and the drive transistor turns on the second node and the third node according to voltages of the first node and the second node, and transmits the voltage signal to a light-emitting device to drive the light-emitting device to emit light.

14. The driving method according to claim 13, wherein the pixel circuit further comprises a first reset module, a second reset module, and a third reset module; the first reset module is connected with a first reset control signal terminal, the first node and a first initialization signal terminal; the second reset module is connected with a second reset control signal terminal, a second initialization signal terminal and the second node; the third reset module is connected with a third reset control signal terminal, a fourth node and a third initialization signal terminal; the refresh frame further comprises a first reset phase, a second reset phase and a third reset phase, during the first reset phase, the first reset module is turned on under control of a first reset control signal and transmits a first initialization signal to the first node; during the second reset phase, the first reset module continues to be turned on, the compensation adjustment module is turned on under the control of the second scan control signal, and transmits the first initialization signal to the first node, the second node and the third node; during the third reset phase, the second reset module and the third reset module are respectively turned on under control of a second reset control signal and a third reset control signal, and the second reset module transmits a second initialization signal received at the second initialization signal terminal to the second node and the third node; the third reset module transmits a third initialization signal received at the third initialization signal terminal to the fourth node.

15. The driving method according to claim 14, wherein a hold frame comprises an adjustment phase in which the light-emitting device continues to emit light, only the second reset module and the third reset module in the pixel circuit are turned on, the second reset module transmits the second initialization signal received at the second initialization signal terminal to the second node, and the third reset module transmits the third initialization signal received at the third initialization signal terminal to the fourth node.

16. A display panel, comprising:

a base substrate and a plurality of sub-pixels located on the base substrate, the sub-pixels are arranged in an array along a first direction and a second direction, at least one sub-pixel comprises a circuit unit and a light-emitting device, the circuit unit comprises a plurality of control signal lines and the pixel circuit according to claims 1-13, the pixel circuit is configured to output a corresponding driving current to the light-emitting device under control of the control signal lines; the pixel circuit comprises a plurality of transistors, each of which comprises a gate, a first electrode and a second electrode; a circuit layer arranged on the base substrate, wherein a plurality of control signal lines extending in the first direction and alternately arranged in the second direction are included in the circuit layer, wherein the first direction and the second direction intersect each other; the control signal line is connected with the gate of the transistor for providing a gate control signal; the gate of at least one transistor and the control signal line are located in different film layers.

17. The display panel according to claim 16, wherein the plurality of transistors comprises a drive transistor, a second transistor and a fourth transistor, a first electrode of the second transistor is connected with a second electrode of the drive transistor, a second electrode of the second transistor is connected with a gate of the drive transistor, a second electrode of the fourth transistor is connected with the first electrode of the drive transistor, the first electrode of the fourth transistor is connected with a data signal line; the control signal line comprises a first scan control signal line and a second scan control signal line, wherein the first scan control signal line is connected with a gate of the fourth transistor for providing a first scan control signal; the second scan control signal line is connected with a gate of the second transistor for providing a second scan control signal; the first scan control signal line and the gate of the fourth transistor are located in different film layers.

18. The display panel according to claim 17, wherein the second scan control signal line and the gate of the second transistor are located in different film layers.

19. The display panel according to claim 17, wherein the pixel circuit further comprises a first transistor, a second electrode of the first transistor is connected to the gate of the drive transistor, and a plurality of first reset control signal lines extending in the first direction and alternately arranged in the second direction are also included in the circuit layer; the first reset control signal line is connected with a gate of the first transistor for providing a first reset control signal; the first reset control signal line and the gate of the first transistor are located in different film layers.

**20.** The display panel according to any one of claims 18 or 19, wherein a conductivity of the control signal line is greater than a conductivity of the gate of the transistor when the control signal line and the gate of the transistor are located in different film layers.

**21.** The display panel according to claim 17, wherein the pixel circuit further comprises a first transistor with a second electrode connected with a gate of the drive transistor and an eighth transistor with a second electrode connected with a first electrode of the drive transistor;

the circuit layer further comprises a plurality of first reset control signal lines and a plurality of third reset control signal lines extending along the first direction and alternately arranged in the second direction, wherein the first reset control signal line and the gate of the first transistor are of an integral structure for providing a first reset control signal, and the third reset control signal line and a gate of the eighth transistor are of an integral structure for providing a third reset control signal;

the pixel circuit further comprises a fifth transistor, a sixth transistor and a seventh transistor, a second electrode of the fifth transistor is connected to a first electrode of the drive transistor, a first electrode of the sixth transistor is connected to a second electrode of the drive transistor, a second electrode of the seventh transistor is connected to a second electrode of the sixth transistor; the third reset control signal line and a gate of the seventh transistor are of an integral structure;

the circuit layer further comprises a plurality of light-emitting control signal lines extending along the first direction, wherein the light-emitting control signal lines and gates of the fifth transistor and the sixth transistor are of an integral structure;

the second scan control signal line and the gate of the second transistor are of an integral structure providing a second scan control signal;

the pixel circuit further comprises a capacitor, the capacitor comprises a first plate and a second plate, the first plate and the gate of the drive transistor are of an integral structure, an orthographic projections of the second plate and the first plate on the base substrate are at least partially overlapped; adjacent second plates in a sub-pixel row arranged in the first direction are connected with each other.

**22.** The display panel according to claim 21, wherein the circuit layer comprises a first semiconductor layer disposed away from the base substrate, the first semiconductor layer comprises active layers of a plurality of transistors, the active layer comprises a first electrode, a second electrode, and a channel region connecting the first electrode and the second electrode of the transistor;

active layers of the first transistor, the second transistor, the drive transistor, the fifth transistor, the sixth transistor and the seventh transistor are of an integral structure, and an orthographic projection of the active layers of the fourth transistor and the eighth transistor on the base substrate does not overlap an orthographic projection of the active layer of the integral structure on the base substrate.

**23.** The display panel according to claim 22, wherein the circuit layer further comprises a first conductive layer disposed on a side of the first semiconductor layer away from the base substrate; the first conductive layer comprises the second scan control signal line, the first reset control signal line, the third reset control signal line, the light-emitting control signal line and the first plate; the first conductive layer further comprises a fourth gate block, the fourth gate block and a gate of the fourth transistor are of an integral structure, and the fourth gate block is located between the first reset control signal line and the second scan control signal line in the second direction.

**24.** The display panel according to claim 23, wherein the circuit layer further comprises a plurality of first initialization signal lines, a plurality of third initialization signal lines, a plurality of data signal lines and a plurality of first power supply voltage lines extending in the second direction;

the first initialization signal line is connected with a first electrode of the first transistor, the third initialization signal line is connected with a first electrode of the eighth transistor, the first power supply voltage line is connected with a second plate of the capacitor and a first electrode of the fifth transistor, and the data signal line is connected with a first electrode of the fourth transistor;

the first initialization signal line connected with a same column of pixel circuits is located between the first power supply voltage line and the data signal line, and the third initialization signal line is located on a side of the data signal line away from the first initialization signal line;

the circuit layer further comprises a plurality of the second initialization signal lines extending along the first direction, the second initialization signal line is connected with a first electrode of the seventh transistor; the second initialization signal line is located on a side of the first reset control signal line away from the second scan control signal line.

**25.** The display panel according to claim 24, wherein the circuit layer further comprises a second conductive layer, a third conductive layer, and a fourth conductive layer sequentially disposed on a side of the first conductive layer away from the first semiconductor layer;

the second conductive layer comprises a second plate of the capacitor and the second initialization signal line; the third conductive layer comprises the first scan control signal line, an orthographic projection of the first scan control signal line on the base substrate and an orthographic projection of the fourth gate block on the base substrate overlap at least partially, with an overlapping area accounting for more than 85% of an area of the fourth gate block;
the fourth conductive layer comprises the data signal line, the first power supply voltage line, the first initialization signal line and the third initialization signal line.

**26.** The display panel according to claim 25, wherein the third conductive layer further comprises a plurality of first adapters extending in the second direction, the first adapter comprises a first end, a third end and a second end between the first end and the third end, a second electrode of the fourth transistor is connected with the first end of the first adapter, a second electrode of the eighth transistor is connected with the third end of the first adapter, the second end of the first adapter is connected to a first electrode of the third transistor through a via;
orthographic projections of the first adapter and the data signal line on the base substrate overlap at least partially, with an overlapping area accounting for more than 90% of an area of the first adapter.

**27.** The display panel according to claim 25, wherein an active layer of the first transistor comprises a channel connection region, and an orthographic projection of the first power supply voltage line on the base substrate overlaps at least partially an orthographic projection of the channel connection region of the first transistor on the base substrate;
the second conductive layer further comprises a shield, an active layer of the second transistor comprises a channel connection region, an orthographic projection of the shield on the base substrate and an orthographic projection of the channel connection region of the second transistor on the base substrate at least partially overlap; and/or, an orthographic projection of the shield on the base substrate at least partially overlaps an orthographic projection of a second electrode of the first transistor on the base substrate; the shield is connected with the third initialization signal line or the first power supply voltage line.

**28.** The display panel according to claim 25, wherein the first initialization signal line is connected with first connection electrode line extending in the first direction through a via to form a grid-like structure; and/or, the second initialization signal line is connected with a second sub-initialization signal line extending in the second direction through a via to form a grid-like structure.

**29.** A display apparatus comprising a display region and at least one peripheral region adjacent to the display region, wherein a plurality of pixel circuits according to any one of claims 1-13 are provided in the display region, and a gate drive circuit is provided in the peripheral region, the gate drive circuit is used for providing corresponding gate signals to a reset control signal terminal, a first scan control signal terminal and a second scan control signal terminal of the pixel circuit;
the gate drive circuit comprises a first gate drive unit and a second gate drive unit, wherein the first gate drive unit is connected with the first scan control signal terminal of various pixel circuits, and the second gate drive unit is connected with the second scan control signal terminal of various pixel circuits; the first gate drive unit is configured to provide a first scan control signal of a first frequency to the first scan control signal terminal; the second gate drive unit is configured to provide a second scan control signal of a second frequency to the second scan control signal terminal; in one refresh frame period, the second frequency is equal to the first frequency, and an effective duration of the second scan control signal is greater than an effective duration of the first scan control signal.

**30.** The display apparatus according to claim 29, wherein the second gate drive unit is further connected with the first reset control signal terminal of various pixel circuits, the first reset control signal terminal and the second scan control signal terminal of a same pixel circuit are respectively connected with output terminals of different stages of the second gate drive unit, and in one refresh frame period, the time when the first reset control signal terminal receives an effective level of the second scan control signal is earlier than the time when the second scan control signal terminal receives an effective level of the second scan control signal.

**31.** The display apparatus according to claim 30, wherein the gate drive circuit further comprises a first reset drive unit connected with a second reset control signal terminal and a third reset control signal terminal of various pixel circuits, the second reset control signal terminal and the third reset control signal terminal of a same pixel circuit are connected with output terminals of a same stage of the first reset drive unit, the first reset drive unit is configured to provide a third reset control signal of a third frequency to the output terminals of the same stage; wherein in a first display mode, the third frequency is greater than the first frequency, and an effective duration of the third reset control signal is equal to an effective duration of the first scan control signal.

2000

FIG. 1

FIG. 2a

FIG. 2b

FIG. 3

FIG. 4

FIG. 5

VDD/Vinit3

12

Re1

N6

T2

Scan2

N5

VDD

131

T1

Vinit1

FIG. 6

| | | P1 | P2 | P3 | P4 | P5 | P6 | | P7 |
|---|---|---|---|---|---|---|---|---|---|

Scan1

Re1

Scan2

Re3
(Re2)

EM

T1

T2

FIG. 7

FIG. 8

FIG. 9

20

FIG. 9a

FIG. 9b

30

FIG. 9c

FIG. 9d

40

410

411    412

FIG. 9e

T7    T8

T1

T4

T2

T3

T5

T6

FIG. 9f

FIG. 9g

FIG. 9h

50

FIG. 9i

50

FIG. 9j

FIG. 9k

FIG. 9l

60

FIG. 9m

FIG. 10

40

FIG. 10a

V21

FIG. 10b

50

FIG. 10c

FIG. 11

40

414-2

414-1

414-3

414

FIG. 11a

V22

FIG. 11b

50

FIG. 11c

V23

FIG. 11d

60

FIG. 11e

20

FIG. 12

FIG. 13

FIG. 14

FIG. 15

FIG. 16

FIG. 17

## INTERNATIONAL SEARCH REPORT

| International application No. |
|---|
| **PCT/CN2022/141896** |

| A. | CLASSIFICATION OF SUBJECT MATTER |
|---|---|

G09G3/32(2016.01)i

According to International Patent Classification (IPC) or to both national classification and IPC

| B. | FIELDS SEARCHED |
|---|---|

Minimum documentation searched (classification system followed by classification symbols)

IPC:G09G3/-

Documentation searched other than minimum documentation to the extent that such documents are included in the fields searched

Electronic data base consulted during the international search (name of data base and, where practicable, search terms used)

CNTXT, CNKI, WPABSC, ENTXTC, ENTXT, DWPI: 像素, 电路, 驱动, 驱动晶体管, 阈值, 补偿, 时间, 时长, 复位, 重置, 数据, 输入, 写入, 发光, 控制, 闪屏, pixel, circuit, drive, transistor, threshold, compensate, time, reset, input, light, control, screen, flash

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 115376461 A (BOE TECHNOLOGY GROUP CO., LTD. et al.) 22 November 2022 (2022-11-22)<br>    description, paragraphs 0051-0159, and figures 1-8 | 13 |
| A | CN 114222615 A (BOE TECHNOLOGY GROUP CO., LTD. et al.) 22 March 2022 (2022-03-22)<br>    entire document | 1-31 |
| A | CN 114495835 A (BOE TECHNOLOGY GROUP CO., LTD. et al.) 13 May 2022 (2022-05-13)<br>    entire document | 1-31 |
| A | CN 115312003 A (WUHAN TIANMA MICRO-ELECTRONICS CO., LTD. et al.) 08 November 2022 (2022-11-08)<br>    entire document | 1-31 |
| A | CN 207217082 U (BOE TECHNOLOGY GROUP CO., LTD.) 10 April 2018 (2018-04-10)<br>    entire document | 1-31 |

☑ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **24 August 2023** | **30 August 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2022/141896**

| C. | DOCUMENTS CONSIDERED TO BE RELEVANT | |
|---|---|---|
| Category* | Citation of document, with indication, where appropriate, of the relevant passages | Relevant to claim No. |
| A | JP 2006308845 A (SEIKO EPSON CORPORATION) 09 November 2006 (2006-11-09) entire document | 1-31 |

Form PCT/ISA/210 (second sheet) (July 2022)

**INTERNATIONAL SEARCH REPORT**
Information on patent family members

International application No.

**PCT/CN2022/141896**

| Patent document cited in search report | | | Publication date (day/month/year) | Patent family member(s) | | | Publication date (day/month/year) |
|---|---|---|---|---|---|---|---|
| CN | 115376461 | A | 22 November 2022 | None | | | |
| CN | 114222615 | A | 22 March 2022 | CN | 114222615 | B | 12 May 2022 |
| CN | 114495835 | A | 13 May 2022 | None | | | |
| CN | 115312003 | A | 08 November 2022 | None | | | |
| CN | 207217082 | U | 10 April 2018 | None | | | |
| JP | 2006308845 | A | 09 November 2006 | JP | 4826131 | B2 | 30 November 2011 |

Form PCT/ISA/210 (patent family annex) (July 2022)